(19) Europäisches Patentamt
European Patent Office
Office européen des brevets

(11) EP 4 112 656 A1

(12) EUROPEAN PATENT APPLICATION
published in accordance with Art. 153(4) EPC

(43) Date of publication:
**04.01.2023 Bulletin 2023/01**

(21) Application number: **21761528.5**

(22) Date of filing: **24.02.2021**

(51) International Patent Classification (IPC):
***C08F 14/18*** (2006.01) ***C08F 14/26*** (2006.01)
***C08L 27/12*** (2006.01) ***H01L 31/10*** (2006.01)
***H01B 5/14*** (2006.01) ***H01B 13/00*** (2006.01)
***H05B 33/10*** (2006.01) ***H01L 51/50*** (2006.01)
***H05B 33/22*** (2006.01) ***H05B 33/26*** (2006.01)

(52) Cooperative Patent Classification (CPC):
**C08F 14/18; C08F 14/26; C08L 27/12; H01B 5/14; H01B 13/00; H01L 31/10; H01L 51/50; H05B 33/10; H05B 33/22; H05B 33/26**

(86) International application number:
**PCT/JP2021/006909**

(87) International publication number:
**WO 2021/172371 (02.09.2021 Gazette 2021/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.02.2020 JP 2020030460**
**30.06.2020 JP 2020112962**
**19.01.2021 JP 2021006634**

(71) Applicant: **AGC INC.**
**Chiyoda-ku,**
**Tokyo 1008405 (JP)**

(72) Inventors:
- **ABE Takefumi**
**Tokyo 100-8405 (JP)**
- **TSURUOKA Kaori**
**Tokyo 100-8405 (JP)**
- **SHIMOHIRA Tetsuji**
**Tokyo 100-8405 (JP)**
- **TAKEI Saki**
**Tokyo 100-8405 (JP)**
- **BEPPU Shotaro**
**Tokyo 100-8405 (JP)**

(74) Representative: **Müller-Boré & Partner Patentanwälte PartG mbB**
**Friedenheimer Brücke 21**
**80639 München (DE)**

# (54) FLUORINE-CONTAINING POLYMER, RESIN FILM, AND OPTO-ELECTRONIC ELEMENT

(57) A fluorinated polymer suitable for deposition and capable of favorable metal patterning, is provided. A resin film containing such a fluorinated polymer as a material is provided. Further, a photoelectronic element having such a resin film in its structure is provided.

A fluorinated polymer which satisfies the following requirements (1) to (3):

(1) the melting point is less than 200°C, or no melting point is observed,

(2) the thermogravimetric loss rate when the temperature is increased at a temperature-increasing rate of 2°C/min under a pressure of $1\times10^{-3}$ Pa, substantially reaches 100% at 400°C or lower,

(3) when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 200°C.

EP 4 112 656 A1

## Description

TECHNICAL FIELD

The present invention relates to a fluorinated polymer, a resin film, and a photoelectronic element.

BACKGROUND ART

Heretofore, as a self-light emitting element, an organic photoelectronic element such as an organic electroluminescence element (an organic EL element) has been known. As an electrically conductive film of such an element, an electrically conductive film having two regions differing in the light transmittance has been known.

In the following explanation, with respect to the two regions differing in the light transmittance, a region with a relatively low light transmittance may sometimes be referred to as a "first region", and a region with a relatively high light transmittance as a "second region". In the case of an organic EL element as an example, for example wiring of the organic EL element corresponds to the first region, and for example a cathode layer constituting an element of the organic EL element corresponds to the second region.

Patent Document 1 discloses, as a method for producing such an electrically conductive film, a method of preliminary forming a patterned film by a material which suppresses formation of a metal film, and then forming a metal film to overlap with the pattern film e.g. by deposition or sputtering.

Specifically, Patent Document 1 discloses as an example of the "material which suppresses formation of a metal film", polytetrafluoroethylene (PTFE). By the above method, a metal film is formed so as to avoid the preliminarily formed patterned film. As a result, on a region in which a patterned film is formed by the material which suppresses formation of a metal film, a second region with a high light transmittance is formed. Further, on a region in which no patterned film is formed, a metal film is formed in a large amount to form a first region with a relatively low light transmittance, whereby an electrically conductive film having the respective regions formed is obtained.

PRIOR ART DOCUMENTS

PATENT DOCUMENT

Patent Document 1: U.S. Patent No. 10270033

DISCLOSURE OF INVENTION

TECHNICAL PROBLEM

A known fluorinated polymer as disclosed in Patent Document 1 is likely to be depolymerized or thermally decomposed at the time of deposition. Further, if an out gas or a partially decomposed product generated by depolymerization or thermal decomposition remains in the electrically conductive film, the performance or the life of an organic EL element having such an electrically conductive film may be deteriorated.

The above problem is not limited to production of an organic EL element and may similarly occur in production of a display device, a photoelectronic element and an organic light emitting element, when a step of depositing a fluororesin is contained.

Under these circumstances, it is an object of the present invention to provide a fluorinated polymer suitable for deposition and capable of favorable metal patterning. Another object is to provide a resin film containing such a fluorinated polymer as a material. Still another object is to provide a photoelectronic element having such a resin film in its structure.

SOLUTION TO PROBLEM

To achieve the above objects, the present invention provides the following.

[1] A fluorinated polymer which satisfies the following requirements (1) to (3):

(1) the melting point is less than 200°C or no melting point is observed,

(2) the thermogravimetric loss rate when the temperature is increased at a temperature-increasing rate of 2°C/min under a pressure of $1\times10^{-3}$ Pa, substantially reaches 100% at 400°C or lower,

(3) when the temperature is increased at a temperature-increasing rate of 2°C/min under a pressure of $1\times10^{-3}$ Pa, the temperature width from a temperature at which the thermogravimetric loss rate is 10% to a temperature

at which it is 90%, is within 200°C.

[2] The fluorinated polymer according to [1], wherein the storage elastic modulus at 40°C is less than $4\times10^7$ Pa.
[3] The fluorinated polymer according to [1] or [2], which has units derived from a fluoroolefin.
[4] The fluorinated polymer according to [3], which has at least units derived from tetrafluoroethylene.
[5] The fluorinated polymer according to [3] or [4], which has units derived from a perfluoroalkyl vinyl ether.
[6] The fluorinated polymer according to [5], wherein the perfluoroalkyl vinyl ether is perfluoropropyl vinyl ether.
[7] The fluorinated polymer according to [6], wherein the content of the units derived from perfluoropropyl vinyl ether to all units is 11 mol% or more.
[8] The fluorinated polymer according to [3] or [4], which further has units derived from hexafluoropropylene.
[9] The fluorinated polymer according to [8], wherein the content of the units derived from hexafluoropropylene to all units is 18 mol% or more.
[10] The fluorinated polymer according to any one of [1] to [9], which has a trifluoromethyl moiety, and has a content of the trifluoromethyl moiety of 0.1 mmol/g or more.
[11] A resin film formed of the fluorinated polymer as defined in any one of [1] to [10] as a material.
[12] A photoelectronic element, comprising the resin film as defined in [11].

ADVANTAGEOUS EFFECTS OF INVENTION

According to the present invention, a fluorinated polymer suitable for deposition and capable of favorable metal patterning is provided. A resin film containing such a fluorinated polymer as a material is provided. Further, a photoelectronic element having such a resin film in its structure is provided.

BRIEF DESCRIPTION OF DRAWINGS

Fig. 1 is a view schematically illustrating the requirements (2) and (3).
Fig. 2 is a plan view illustrating an electrically conductive film 1.
Fig. 3 is a schematic arrow view at segment III-III in Fig. 2.
Fig. 4 is a schematic view illustrating a method for producing the electrically conductive film 1.
Fig. 5 is a schematic view illustrating a method for producing the electrically conductive film 1.
Fig. 6 is a schematic view illustrating a method for producing the electrically conductive film 1.
Fig. 7 is a schematic cross sectional view illustrating a photoelectronic element (an organic EL element) 100 according to a second embodiment.

DESCRIPTION OF EMBODIMENTS

A "unit" constituting a polymer in this specification means a moiety present in the polymer to constitute the polymer, derived from one molecule of a monomer (that is a monomer unit). Hereinafter, a unit derived from each monomer may sometimes be represented as the monomer name followed by "unit".
In this specification, the "main chain" of a polymer means a carbon atom chain constituted by addition polymerization of a monomer having a carbon-carbon unsaturated double bond, constituted by the carbon atoms which have constituted the carbon-carbon unsaturated double bond in the monomer.
A "reactive functional group" means a group having reactivity capable of reacting intermolecularly in the fluorinated polymer or with other component blended with the fluorinated polymer (excluding radial reaction) to form a bond, e.g. when heated.
In this specification, an "aliphatic ring" means not only a carbocyclic ring having the cyclic skeleton constituted solely of carbon atoms but also a heterocyclic ring having the cyclic skeleton containing an atom (hetero atom) other than carbon atoms. The hetero atom may, for example, be an oxygen atom, a nitrogen atom or a sulfur atom.

[First embodiment]

Now, the fluorinated polymer and the resin film according to a first embodiment of the present invention will be described with reference to Figs. 1 to 6. In the drawings, for visibility, the dimensions, the ratios, etc. of the constituting elements are properly changed.

(Fluorinated polymer)

The fluorinated polymer according to the present embodiment satisfies the following requirements (1) to (3).

Requirement (1): the melting point is less than 200°C, or no melting point is observed.
Requirement (2): the thermogravimetric loss rate when the temperature is increased at a temperature-increasing rate of 2°C/min under a pressure of $1\times10^{-3}$ Pa, substantially reaches 100% at 400°C or lower,
Requirement (3): when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 200°C.

The fluorinated polymer which satisfies the above requirements (1) to (3) has physical properties suitable for deposition and is capable of favorably forming a deposited film. Further, when the obtained deposited film is used, pattering of a metal film will readily be conducted.
Explanations will be made in order.

(Requirement (1))

The fluorinated polymer according to the present embodiment has a melting point of less than 200°C, or has no melting point observed. The fluorinated polymer preferably has a melting point observed within a predetermined range. When the melting point of the fluorinated polymer is observed, the melting point of the fluorinated polymer is preferably 190°C or lower, more preferably 180°C or lower. The lower limit of the melting point is not particularly limited, and is preferably 100°C or higher, so that the shape of the film formed of the fluorinated polymer is well maintained.
In the present embodiment, as the melting point, a value measured by a differential scanning calorimeter (for example, manufactured by NETZSCH, DSC 204 F1 Phoenix) is employed. Specifically, 9 mg of the fluorinated polymer is put in a sample container, the heat capacity when the temperature is increased from -70°C to 350°C at a rate of 10°C per minute is measured, and the melting point is determined from the obtained melting peak.
The fluorinated polymer having the above melting point can be judged as having low crystallinity. In a case where a metal material is to be deposited on a resin film formed of a fluorinated polymer, as a material, when the resin film contains crystals of the fluorinated polymer in a large amount, the grain boundaries (interfaces) of the crystals of the fluorinated polymer tend to be an origin of nucleation of the deposition material (metal), and a metal film is likely to be formed on the resin film. On the other hand, when the amount of the crystals of the fluorinated polymer contained in the resin film is small, a metal film is less likely to be formed on the resin film.
That is, when the fluorinated polymer satisfies the requirement (1) and has lower crystallinity, a metal film is less likely to be formed on the resin film formed of the fluorinated polymer as a material, and due to a difference with the periphery of the resin film on which a metal film is relatively likely to be formed, a patterned metal film is likely to be formed.
For example, in a case where the fluorinated polymer has units derived from perfluoropropyl vinyl ether (PPVE) (PPVE units), as the content of the PPVE units increases, the crystallinity of the fluorinated polymer decreases and at the same time, the melting point decreases.
Further, a fluorinated polymer, which has an alicyclic structure in its main chain, is likely to have low crystallinity or amorphous property since the alicyclic structure is likely to collapse the crystallinity. In a case where the fluorinated polymer is amorphous, no melting point is observed.

(Requirement (2))

In the following explanation, the "temperature at which the thermogravimetric loss rate substantially reaches 100% when the temperature of the fluorinated polymer is increased at a temperature-increasing rate of 2°C/min under a pressure of $1\times10^{-3}$ Pa", will sometimes be referred to as "100% thermogravimetric loss temperature" (°C). The requirement (2) specifies that the 100% thermogravimetric loss temperature is 400°C or lower.
In the present embodiment, as the thermogravimetric loss rate of the fluorinated polymer, a value measured by a vacuum differential thermobalance (manufactured by ADVANCE RIKO, Inc., VPE-9000) is employed. Specifically, 50 mg of the fluorinated polymer is put int a cell having an inner diameter of 7 mm, and the weight loss (%) of the fluorinated polymer when the temperature is increased from room temperature to 500°C at a rate of 2°C per minute in a degree of vacuum of $1\times10^{-3}$ Pa, to the initial weight (50 mg), is measured.
In the requirement (2), "substantially" means that when the thermogravimetric loss rate is measured under the above conditions, the thermogravimetric loss in a temperature range of 400°C or lower is lower than the detection lower limit and the thermogravimetric loss can not be confirmed.

The fluorinated polymer according to the present embodiment may be considered to have a lower molecular weight (degree of polymerization) as the temperature which satisfies the requirement (2) is lower.

Assuming that a fluorinated polymer which does not satisfy the requirement (2) is to be deposited, it has to be heated to a temperature higher than 400°C. If the fluorinated polymer is to be heated in a temperature range higher than 400°C, the fluorinated polymer may be depolymerized or thermally decomposed due to high temperature. In such a case, products formed by depolymerization or thermal decomposition may increase the internal pressure of a vacuum chamber used for deposition. If the internal pressure of a vacuum chamber is increased, the deposition conditions tend to be unstable, and the quality of the obtainable deposited film (resin film) may not be stable.

Further, if a fluorinated polymer which does not satisfy the requirement (2) is heated in a temperature range higher than 400°C, a fluorinated polymer partially depolymerized or thermally decomposed and thus having a low molecular weight may be included in the resin film, thus lowering the heat resistance of the resin film.

Further, if a fluorinated polymer which does not satisfy the requirement (2) is heated in a temperature range higher than 400°C, a fluorinated polymer having an unstable terminal formed by depolymerization or thermal decomposition may be included in the resin film, thus impairing the quality of the resin film or an element containing the resin film.

On the other hand, the fluorinated polymer which satisfies the requirement (2) can be suitably used for deposition by heating to a temperature of 400°C or lower, as a material of deposition conducted in vacuum. Thus, it will not be depolymerized or thermally decomposed and can be used for deposition under stable deposition conditions.

The fluorinated polymer according to the present embodiment is preferably such that the thermogravimetric loss rate when the temperature is increased at a temperature-increasing rate of 2°C/min under a pressure of $1\times10^{-3}$ Pa, substantially reaches 100% at 350°C or lower, that is, a temperature at which the thermogravimetric loss rate substantially reaches 100% is 350°C or lower.

(Requirement (3))

In the following explanation, "a temperature width from a temperature at which the thermogravimetric loss rate is 10% to a temperature at which it is 90%, when the temperature of the fluorinated polymer is increased at a temperature-increasing rate of 2°C/min under a pressure of $1\times10^{-3}$ Pa", will sometimes be referred to as "thermogravimetric loss temperature range" (°C). The requirement (3) is to specify that the thermogravimetric loss temperature range is within 200°C.

The fluorinated polymer according to the present embodiment is considered to have a narrower molecular weight distribution as the temperature width which satisfies the requirement (3) is narrower.

When a resin film is to be produced by using a fluorinated polymer which does not satisfy the requirement (3), the difference between the molecular weight of the fluorinated polymer deposited at the initial stage of the deposition and the molecular weight of the fluorinated polymer deposited at the final stage of the deposition tends to be significant, whereby in a single resin film, the molecular weight of the fluorinated polymer may change in the resin film thickness direction, and the physical properties of the resin film may not be stable.

Further, in a case where a resin film is produced continuously under the same conditions, if a fluorinated polymer which does not satisfy the requirement (3) is used, resin films produced may not be uniform in quality among lots.

Further, a low molecular weight product contained in the fluorinated polymer may form as out gas at the time of deposition, be attached to the interior of a vacuum chamber and contaminate the vacuum chamber. For example, in the process for producing a photoelectronic element, such a contamination source may cause a reduction of the life of the element or may cause short-circuiting, and thus remarkably impair the quality of the element.

On the other hand, with the fluorinated polymer which satisfies the requirement (3), the difference between the molecular weight of the fluorinated polymer deposited at the initial stage of the deposition and the molecular weight of the fluorinated polymer deposited at the final stage of the deposition tends to be small, whereby the change of the molecular weight of the fluorinated polymer in the resin film thickness direction tends to be small. Thus, the physical properties of the obtainable resin film tend to be stable.

Further, in a case where a resin film is produced continuously under the same conditions, non-uniformity of the resin films produced in quality among lots can be suppressed.

Further, since no low molecular weight product which may cause an out gas is contained, the vacuum chamber will not be contaminated.

As a method to obtain the fluorinated polymer having a narrow molecular weight distribution, which satisfies the requirement (3), molecular weight adjustment by controlled polymerization such as living radical polymerization, or a molecular weight fractionation method by sublimation purification, supercritical extraction or size exclusion chromatography, may be mentioned.

Fig. 1 is a view schematically illustrating requirements (2) and (3), and is a graph illustrating the relation of the thermogravimetric loss rate to the measurement temperature. The horizontal axis of Fig. 1 indicates the measurement temperature (unit: °C), and the vertical axis indicates the thermogravimetric loss rate (unit: %). In Fig. 1, the behavior of

the fluorinated polymer which satisfies the requirements (2) and (3) is indicated by the reference P, and the behavior of the fluorinated polymer which does not satisfy the requirements (2) and (3) is indicated by the reference Px.

In Fig. 1, the graph P indicating the behavior of the fluorinated polymer according to the present embodiment, reaches a thermogravimetric loss rate of 100% at a temperature ($T_{d100}$) lower than 400°C. Whereas the graph Px indicating the behavior of the fluorinated polymer which does not satisfy the requirements (2) and (3), does not reach a thermogravimetric loss rate of 100% at 400°C.

Further, in Fig. 1, the graph P indicating the behavior of the fluorinated polymer according to the present embodiment has a value W which is $T_{d90}$-$T_{d10}$ of 200°C or less.

It is found from Fig. 1 that the fluorinated polymer according to the present embodiment undergoes steep thermogravimetric loss between the temperature $T_{d10}$ and the temperature $T_{d90}$.

Whether the fluorinated polymer is depolymerized or thermally decomposed at the time of deposition, and an out gas is generated, may be evaluated as follows, focusing on the change of the internal pressure in a vacuum chamber.

(Method of evaluating chamber pressure change at the time of deposition)

0.1 g of a fluorinated polymer is put in a vacuum deposition apparatus, the pressure in the chamber is reduced to $10^{-4}$ Pa or lower, and the fluorinated polymer is deposited in a thickness of 200 nm at a deposition rate of 0.1 nm/sec. On that occasion, the pressure in the chamber is monitored, and the maximum value of the pressure at the time of deposition is measured.

A fluorinated polymer with a chamber pressure increase ratio determined in accordance with the following formula of 10 times or less, can be suitably used for deposition with small depolymerization, thermal decomposition and an out gas.

Chamber pressure increase ratio at the time of deposition= maximum pressure during deposition/initial pressure before deposition

A fluorinated polymer with a chamber pressure increase ratio of higher than 10 times is judged unsuitable for deposition, with significant depolymerization, thermal decomposition or an out gas.

(Molecular weight fractionation)

If the fluorinated polymer to be used does not satisfy the requirements (2) and (3), by molecular weight fractionation of the fluorinated polymer, a fluorinated polymer according to the present embodiment, which satisfies the requirements (2) and (3), can be obtained.

The fluorinated polymer which satisfies the requirements (2) and (3) may be obtained by molecular weight fractionation of a polymer. In the following description, a polymer to be subjected to the molecular weight fractionation will sometimes be referred to as "raw material polymer".

As a method of molecular weight fractionation, for example, a method of fractionating a polymer by the molecular weight by sublimation purification or supercritical extraction, or by size exclusion chromatography, to adjust the polymer to satisfy the requirements (2) and (3).

(Sublimation purification)

Sublimation purification is a means such that an object to be purified (raw material polymer) is heated under reduced pressure to sublimate or evaporate a part or the whole of the object to be purified, and utilizing a precipitation temperature difference among compounds contained in the gaseous state object to be purified, the desired compound is isolated and recovered as a solid. Such sublimation purification may be conducted by using a sublimation purification apparatus having a charge portion in which the object to be purified is put, and a collecting portion which isolates the gaseous state object to be purified by the precipitation temperature and collects each fraction as a solid, and being capable of maintaining a high degree of vacuum.

The structure of the sublimation purification apparatus is not particularly limited, and for example, so-called Mill-type sublimation purification apparatus comprising a glass condenser tube, a flask-shaped glass container surrounding the condenser tube, and a vacuum exhaust device which depressurizes the interior of the glass container, may be used. Further, as the sublimation purification apparatus, a glass tube-type sublimation purification apparatus comprising a cylindrical glass sublimation tube, a heating device which contains the sublimation tube in its interior and heats the sublimation tube, and a high vacuum exhaust device which depressurizes the interior of the sublimation tube, may also be used.

Now, sublimation purification of a fluorinated polymer and a molecular weight fractionation method by sublimation purification will be described with reference to a glass tube-type sublimation purification apparatus as an example.

In sublimation purification of a fluorinated polymer, a raw material polymer is put in the charge portion of the

sublimation tube, and the degree of vacuum in the sublimation tube is increased, for example, to a pressure of $1\times10^{-3}$ Pa or lower by the high vacuum exhaust device, and then the charge portion is heated by the heating device, whereby the fluorinated polymer contained in the raw material polymer is sublimated or evaporated.

A region on the side closer to exhaust by the high vacuum exhaust device than the charge portion, in the sublimation tube, corresponds to a "collecting portion". The collecting portion is set to have a temperature lower than the heating temperature in the charge portion. The fluorinated polymer sublimated or evaporated from the raw material polymer in the charge portion is precipitated and solidified on the wall of the collecting portion, or liquified on the wall of the collecting portion, and is collected.

The collecting temperature in the collecting portion corresponds to a temperature at which the fluorinated polymer is sublimated from a gas to a solid (precipitation temperature) or to a temperature at which the fluorinated polymer is condensed from a gas to a liquid, and corresponds to the molecular weight of the fluorinated polymer. By providing a plurality of collecting portions differing in the collecting temperature in the sublimation tube, the raw material polymer can be separated into fluorinated polymer fractions differing in the molecular weight.

For example, specifically, in a case where the charge portion is heated to A °C and the collecting portions are heated to B °C and C °C from the side closer to the charge portion (A>B>C), in the collecting portion set to B °C, a fluorinated polymer within a molecular weight range such that it is in a gaseous state at A °C and is in a solid (or liquid) state at B °C is collected.

Likewise, in the collecting portion set to C °C, a fluorinated polymer within a molecular weight range such that it is in a gaseous state at B °C and is in a solid (or liquid) state at C °C is collected. That is, in the collecting portion set to C °C, among fluorinated polymer fractions contained in the raw material polymer, a fluorinated polymer with a collecting temperature width B °C-C °C, which is in a gaseous state at B°C and which is in a solid (or liquid) state at C °C, is collected.

The above requirement (3) may be satisfied by controlling the collecting temperature width as described above and collecting the fluorinated polymer in a collecting portion with a collecting temperature width of 200°C for example. The collected fluorinated polymer is confirmed whether it satisfies the requirement (3) or not, and if not, the temperature conditions of the collecting portion should be controlled to narrow the collecting temperature width.

A fluorinated polymer collected in a lower set temperature region in the collecting portion, is a fluorinated polymer such that its thermogravimetric loss rate reaches 100% at a lower temperature under a pressure of $1\times10^{-3}$ Pa, that is, it is a fluorinated polymer with a lower molecular weight.

The collecting temperature width is preferably 200°C or lower, more preferably 100°C or lower, further preferably 50°C or lower. The smaller the collecting temperature width is, the smaller the variation of the deposition conditions tends to be, and the more stable the quality of the resin film tends to be.

Fluorinated polymer fractions differing in the collecting temperature width, separated by the molecular weight, may be mixed so long as the requirements (2) and (3) are satisfied.

(Supercritical extraction)

Supercritical extraction is a technique to obtain an extract utilizing high solubility and diffusibility of a supercritical fluid. In supercritical extraction, for example, a fluorinated polymer having a relatively low molecular weight is dissolved in supercritical $CO_2$ used as the supercritical fluid, and an extract is obtained.

Further, by using a fluorinated solvent as an additive (entrainer) to the supercritical fluid, solubility of the fluorinated polymer in the supercritical fluid can be increased.

The fluorinated solvent used as the entrainer is not particularly limited. For example, a fluorinated solvent with a fluorophilicity parameter $P_F$ of 1 or more as determined by the following method is preferred.

(Fluorophilicity parameter $P_F$)

To a two-phase system of 3 g of toluene and 3 g of perfluoromethylcyclohexane, 30 μL of the fluorinated solvent is dropwise added and thoroughly mixed, and left at rest overnight. Then, the fluorinated solvent contained in the toluene and the fluorinated solvent contained in the perfluoromethylcyclohexane are measured by gas chromatography. A value determined in accordance with the following formula (A), wherein $M_P$ is the concentration (unit: mL/L) of the fluorinated solvent in the toluene, and $M_F$ is the concentration (unit: mL/L) of the fluorinated solvent in the perfluoromethylcyclohexane, is taken as the fluorophilicity parameter $P_F$.

$$P_F=M_F/M_P \quad (A)$$

As the fluorinated solvent used as the entrainer, for example, the following compounds may be mentioned.

1,1,1,2,2,3,3,4,4,5,5,6,6-tridecafluorohexane (AC-2000, manufactured byAGC Inc.) ($P_F$=12)
1,1,1,2,2,3,3,4,4,5,5,6,6-tridecafluorooctane (AC-6000, manufactured byAGC Inc.) ($P_F$=5.6)
CYTOP CT-SOLV100E (manufactured by AGC Inc.) ($P_F$=8.2)
CYTOP CT-SOLV180 (manufactured by AGC Inc.) ($P_F=\infty$)
HFE7300 (manufactured by 3M) ($P_F$=8.2)
1,1,1,2,2,3,4,5,5,5-decafluoropentane (Vertre XF, manufactured by Chemours) (PF=3.7)
1H,1H,2H,2H-perfluorooctanol ($P_F$=1.1)
1,1,2,2-tetrafluoroethyl-2,2,2-trifluoroethyl ether (AE-3000, manufactured by AGC Inc.) ($P_F$=0.6)
HCFC-225ca/HCFC-225cb (45/55) ($P_F$=0.3)
Perfluorobenzene ($P_F$=0.3)
Hexafluoro-2-propanol ($P_F$=0.24)
1H,1H,7H-perfluoroheptanol ($P_F$=0.23)
1H,1H,5H-perfluoropentanol ($P_F$=0.1)

The extraction step may be conducted, for example, by using supercritical $CO_2$ under an extraction pressure of 7.4 MPa or higher at an extraction temperature of 31°C or higher.

The extraction pressure is preferably 30 MPa or higher, more preferably 50 MPa or higher, further preferably 70 MPa or higher. The upper limit of the extraction pressure is not particularly limited and is preferably 100 MPa or lower. The upper limit and the lower limit of the extraction pressure may optionally be combined.

The extraction temperature is preferably 40°C or higher, more preferably 80°C or higher. The extraction temperature is preferably 300°C or lower, more preferably 200°C or lower, further preferably 100°C or lower. The upper limit and the lower limit of the extraction temperature may optionally be combined.

Within the above range, the desired fluorinated polymer can efficiently be obtained by molecular weight fractionation.

Molecular weight fractionation is useful also for removing remaining foreign matters such as the initiator, the chain transfer agent and the solvent used in the step of polymerization for the fluorinated polymer, and by-products. Such remaining foreign matters may form as an out gas at the time of deposition and be attached to the interior of a vacuum chamber and contaminate the vacuum chamber. Accordingly, even when the requirements (2) and (3) are satisfied, sublimation purification or supercritical extraction is more preferably carried out.

Fluorinated polymer fractions differing in the extraction conditions, separated by the molecular weight, may be mixed so long as the requirements (2) and (3) are satisfied.

(Other requirements)

The fluorinated polymer according to the present embodiment preferably satisfies the following requirement (4).

Requirement (4): the storage elastic modulus at 25°C is less than $4\times10^7$ Pa.

A fluorinated polymer which satisfies the requirement (4) has high flexibility and is excellent in following property when its shape is changed. Accordingly, when a fluorinated polymer which satisfies the requirement (4) is used as a material of a resin film in a flexible apparatus, the resin film relaxes shear stress generated when the apparatus is bent, at the interface with a layer in contact with the resin film. Thus, it is expected that breakage when the apparatus is bent can be suppressed.

As the flexible apparatus, for example, a foldable display may be mentioned.

Further, a fluorinated polymer which satisfies the requirement (4) has a low melt viscosity. Accordingly, a fluorinated polymer which satisfies the requirement (4) has a low viscosity under heating when used as a deposition material, surface renewal of the material will be smoothly conducted by convection, and excellent deposition stability will be achieved. Further, by the surface renewal by convection, partial overheating of the deposition material will be suppressed, and thermal deposition by excessive heating can be avoided.

The fluorinated polymer which satisfies the requirement (4) is obtained, for example, by changing the content of the PPVE units in the fluorinated polymer. As the content of PPVE units increases, the storage elastic modulus tends to decrease.

Likewise, the fluorinated polymer which satisfies the requirement (4) may be obtained, for example, by changing the content of units derived from hexafluoropropylene (HFP) (HFP units) in the fluorinated polymer. The storage elastic modulus tends to decrease as the content of the HFP units increases.

In the present embodiment, as the storage elastic modulus, a value measured by a dynamic viscoelasticity measuring device (for example, manufactured by Anton Paar, MCR502) and a heating furnace for a viscoelasticity measuring device (for example, manufactured by Anton Paar, CTD450) is employed. Specifically, a sample (the fluorinated polymer) is heated to the melting point or higher and then its temperature is decreased at constant temperature-decreasing mode at 2°C/min. Using the above measuring device, the storage elastic modulus (G') is measured with a

distortion of 0.01% at a frequency of 1 Hz.

(Structure of fluorinated polymer)

The fluorinated polymer according to the present embodiment is not restricted with respect to its units so long as it is a fluorinated polymer which satisfies the above requirements (1) to (3).

The fluorine atom content of the fluorinated polymer is preferably 20 mass% or more, more preferably 40 mass% or more, further preferably 60 mass% or more, particularly preferably 70 mass% or more. The higher the fluorine atom content is, the lower the surface energy of a resin film formed of the fluorinated polymer as a material tends to be, and the less the metal film will be formed on the surface of the resin film. Accordingly, by using a fluorinated polymer having such a fluorine atom content, a patterned metal film is likely to be formed.

The fluorine atom content (mass%) is obtained in accordance with the following formula.

$$(\text{Fluorine atom content})=[19\times NF/MA]\times 100$$

NF: the sum of products of the total atomic weight of fluorine atoms constituting each type of units constituting the fluorinated polymer, and the mole fraction of the units to all units.
MA: the sum of products of the total atomic weight of all atoms constituting each type of units constituting the fluorinated polymer, and the mole fraction of the units to all units.

The above NF and MA are calculated by the mole fraction of the constituting units and the amount of terminals of the fluorinated polymer, obtained by $^{1}$H-NMR, $^{19}$F-NMR, elemental analysis and IR. Further, NF and MA may also be calculated from the amounts of monomers and an initiator charged in production of the fluorinated polymer.

The fluorinated polymer preferably has a trifluoromethyl moiety. The "trifluoromethyl moiety" means $CF_3$-. The trifluoromethyl moiety includes, in addition to a trifluoromethyl group, a part of a structure of a substituent, such as $CF_3$- contained in a pentafluoroethyl group.

The content of the trifluoromethyl moiety is preferably 0.1 mmol/g or more, more preferably 0.3 mmol/g or more, further preferably 0.6 mmol/g or more. The higher the content of the trifluoromethyl moiety is, the lower the surface energy of the resin film formed of the fluorinated polymer as a material tends to be. Thus, a metal film can hardly be formed on the surface of the resin film, and a patterned metal film will readily be obtained.

The content (mmol/g) of the trifluoromethyl moiety is obtained in accordance with the following formula.

$$(\text{Content of trifluoromethyl moiety})=[NCF_3/MA]\times 1{,}000$$

$NCF_3$: the sum of products of the number of moles of the trifluoromethyl moiety constituting each type of units constituting the fluorinated polymer, and the mole fraction of the units to all units.
MA: the sum of products of the total atomic weight of all atoms constituting each type of units constituting the fluorinated polymer, and the mole fraction of the units to all units.

The above $NCF_3$ and MA are calculated by the mole fraction of the constituting units and the amount of terminals of the fluorinated polymer, obtained by $^{1}$H-NMR, $^{19}$F-NMR, elemental analysis and IR. Further, $NCF_3$ and MA may also be calculated from the amounts of monomers and an initiator charged in production of the fluorinated polymer.

The fluorinated polymer is preferably the following polymer (1) or polymer (2).

Polymer (1): a fluorinated polymer having no aliphatic ring in its main chain and having fluoroolefin units.
Polymer (2): a fluorinated polymer having an aliphatic ring in its main chain.

In the present invention, as the fluorinated polymer, only one of the polymers (1) and (2) may be used, or both the polymers (1) and (2) may be used in combination.

<<polymer (1)>>

The polymer (1) may be a homopolymer of a fluoroolefin, may be a copolymer of two or more types of fluoroolefins, or may be a copolymer of a fluoroolefin and a monomer copolymerizable with a fluoroolefin.

The fluoroolefin may be a perfluoroolefin such as tetrafluoroethylene (TFE) or hexafluoropropylene (HFP), or a perfluoroalkyl vinyl ether such as perfluoromethyl vinyl ether (PMVE), perfluoroethyl vinyl ether (PEVE) or perfluoropropyl vinyl ether (PPVE).

As the fluoroolefin, a fluoroolefin containing a hydrogen atom or a chlorine atom, such as chlorotrifluoroethylene (CTFE), trifluoroethylene (TrFE), vinylidene fluoride (VdF), 1,2-difluoroethylene or 1-fluoroethylene may also be mentioned.

The monomer copolymerizable with a fluoroolefin may, for example, be an olefin such as ethylene or propylene, a vinyl ether, a vinyl ester, an aromatic vinyl compound such as styrene, an allyl compound such as an allyl ether, an acryloyl compound or a methacryloyl compound.

Further, a fluorinated monomer having a perfluoroalkyl group or a perfluoropolyether group, such as a vinyl ether, a vinyl ester, an aromatic vinyl compound, an allyl compound, an acryloyl compound or a methacryloyl compound, may also be used.

Among them, the polymer (1) preferably has perfluoroalkyl vinyl ether units. More specifically, the fluorinated polymer preferably has PPVE units.

When the content of the PPVE units in the polymer (1) changes, the crystallinity changes. Specifically, as the content of the PPVE units in the fluorinated polymer increases, the crystallinity of the fluorinated polymer decreases.

The content of the PPVE units is, to the total number of moles of all monomer units constituting the fluorinated polymer, preferably 11 mol% or more, more preferably 12 mol% or more, further preferably 14 mol%. The content of the PPVE units is, to the total number of moles of all monomer units constituting the fluorinated polymer, preferably 25 mol% or less.

When the content of the PPVE units is within the above range, the melting point of the fluorinated polymer satisfies the requirement (1), and favorable deposition will be possible.

Further, the polymer (1) preferably has HFP units.

When the content of the HFP units in the polymer (1) changes, the crystallinity changes. Specifically, when the content of the HFP units in the fluorinated polymer increases, the crystallinity of the fluorinated polymer decreases.

The content of the HFP units is, to the total number of moles of all monomer units constituting the fluorinated polymer, preferably 18 mol% or more, more preferably 20 mol%. Further, the content of the HFP units is, to the total number of moles of all monomer units constituting the fluorinated polymer, preferably 25 mol% or less.

When the content of the HFP units is within the above range, the melting point of the fluorinated polymer satisfies the requirement (1), and favorable deposition will be possible.

In a case where the polymer (1) is a copolymer, the content of the fluoroolefin units is preferably 20 mol% or more, more preferably 40 mol% or more, further preferably 80 mol% or more.

The polymer (1) may be a synthetic product or may be a commercial product.

As the polymer (1), the following polymers, etc., may be mentioned.

Polytetrafluoroethylene (PTFE)
Tetrafluoroethylene/perfluoro(alkyl vinyl ether) copolymer (PFA)
Tetrafluoroethylene/hexafluoropropylene copolymer (FEP)
Tetrafluoroethylene/perfluoro(alkyl vinyl ether)/hexafluoropropylene copolymer (EPA)
Ethylene/tetrafluoroethylene copolymer (ETFE)
Polyvinylidene fluoride (PVDF)
Polyvinyl fluoride (PVF)
Polychlorotrifluoroethylene (PCTFE)
Ethylene/chlorotrifluoroethylene copolymer (ECTFE)

Among them, in that a metal film can hardly be deposited on the surface of a film formed of the fluorinated polymer as a material and pattering will readily be conducted, preferred is a polymer having all hydrogen atoms bonded to a carbon atom replaced with fluorine. That is, PTFE, PFA, FEP or EPA is preferred.

The polymer (1) may be produced by a known method.

The polymer (1) may be a synthetic product or may be a commercial product.

<<polymer (2)>>

The polymer (2) is a fluorinated polymer having an aliphatic ring in its main chain.

The "fluorinated polymer having an aliphatic ring in its main chain" means a fluorinated polymer having units having an aliphatic ring structure and at least one of carbon atoms constituting the aliphatic ring being a carbon atom constituting the main chain. The aliphatic ring may be a ring having a hetero atom such as an oxygen atom.

The "main chain" of a polymer means, in the case of a polymer of a monoene, a chain of carbon atoms derived from the two carbon atoms constituting the polymerizable double bond.

Further, in the case of a cyclic polymer of a cyclopolymerizable diene, it means a chain of carbon atoms derived

from the four carbon atoms constituting the two polymerizable double bonds.

Further, in the case of a copolymer of a monoene and a cyclopolymerizable diene, it means a chain of carbon atoms derived form the two carbon atoms of the monoene and the four carbon atoms of the diene.

In a case where the monoene is a monoene having a polymerizable double bond between one carbon atom constituting a ring skeleton of an aliphatic ring and a carbon atom outside the ring, the main chain of the polymer having an aliphatic ring in its main chain has one carbon atom constituting the ring skeleton which has constituted the polymerizable double bond of the monoene. Further, in a case where the monoene is a monoene having a polymerizable double bond between adjacent two carbon atoms constituting the ring skeleton of an aliphatic ring, the main chain of the polymer having an aliphatic ring in its main chain has two carbon atoms constituting the ring skeleton which has constituted the polymerizable double bond of the monoene.

In the case of the cyclopolymerizable diene, the main chain of a polymer having an aliphatic ring in its main chain is constituted by four carbon atoms which have constituted the two polymerizable double bonds of the diene, and two to four among the four carbon atoms constitute the ring skeleton of the aliphatic ring.

The number of carbon atoms constituting the ring skeleton of the aliphatic ring in the polymer (2) is preferably from 4 to 7, particularly preferably from 5 to 6. That is, the aliphatic ring is preferably a 4- to 7-membered ring, particularly preferably a 5- to 6-membered ring. In a case where the aliphatic ring has a hetero atom as a ring-constituting atom, the hetero atom may be an oxygen atom, a nitrogen atom or the like, and is preferably an oxygen atom. The number of the hetero atom constituting the ring is preferably from 1 to 3, more preferably 1 or 2.

The aliphatic ring may or may not have a substituent. "may have a substituent" means that a substituent may be bonded to an atom constituting the ring skeleton of the aliphatic ring.

The hydrogen atom bonded to a carbon atom constituting the aliphatic ring of the polymer (2) is preferably replaced with a fluorine atom. In a case where the aliphatic ring has a substituent which has a hydrogen atom bonded to its carbon atom also, the hydrogen atom is preferably replaced with a fluorine atom. The substituent having a fluorine atom may, for example, be a perfluoroalkyl group, a perfluoroalkoxy group or =CF2.

The aliphatic ring in the polymer (2) is preferably a perfluoroaliphatic ring (an aliphatic ring having all hydrogen atoms bonded to a carbon atom, including the substituent, replaced with fluorine atoms).

As the polymer (2), the following polymers (21) and (22) may be mentioned.

Polymer (21): a fluorinated polymer having units derived from a cyclic fluorinated monoene.
Polymer (22): a fluorinated polymer having units formed by cyclopolymerization of a cyclopolymerizable diene (hereinafter sometimes referred to simply as "fluorinated diene").

Polymer (21):

The "fluorinated cyclic monoene" is a fluorinated monomer having one polymerizable double bond between carbon atoms constituting the aliphatic ring, or a fluorinated monomer having one polymerizable double bond between a carbon atom constituting the aliphatic ring and a carbon atom outside the aliphatic ring.

The fluorinated cyclic monoene is preferably the following compound (1) or (2).

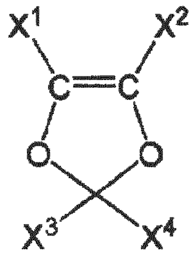

(1)

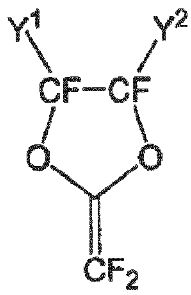

(2)

wherein $X^1$, $X^2$, $X^3$, $X^4$, $Y^1$ and $Y^2$ are each independently a fluorine atom, a perfluoroalkyl group which may contain an etheric oxygen atom (-O-), or a perfluoroalkoxy group which may contain an etheric oxygen atom, and $X^3$ and $X^4$ may be mutually bonded to form a ring.

The perfluoroalkyl group as each of $X^1$, $X^2$, $X^3$, $X^4$, $Y^1$ and $Y^2$ has preferably from 1 to 7, particularly preferably from 1 to 4 carbon atoms. The perfluoroalkyl group is preferably linear or branched, particularly preferably linear. Specifically, it may be a trifluoromethyl group, a pentafluoroethyl group or a heptafluoropropyl group, and is particularly preferably a trifluoromethyl group.

The perfluoroalkoxy group as each of $X^1$, $X^2$, $X^3$, $X^4$, $Y^1$ and $Y^2$ may be one having an oxygen atom (-O-) bonded to the perfluoroalkyl group, particularly preferably a trifluoromethoxy group.

In the formula (1), $X^1$ is preferably a fluorine atom.

$X^2$ is preferably a fluorine atom, a trifluoromethyl group or a $C_{1-4}$ perfluoroalkoxy group, particularly preferably a fluorine atom or a trifluoromethoxy group.

$X^3$ and $X^4$ are preferably each independently a fluorine atom or a $C_{1-4}$ perfluoroalkyl group, particularly preferably a fluorine atom or a trifluoromethyl group.

$X^3$ and $X^4$ may be mutually bonded to form a ring. The number of atoms constituting the ring skeleton of the ring is preferably from 4 to 7, particularly preferably from 5 to 6.

As specific examples of preferred compound (1), compounds (1-1) to (1-5) may be mentioned.

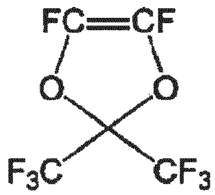
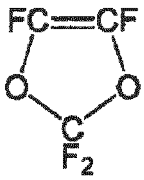
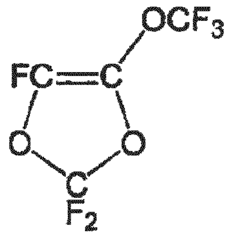

(1-1) (1-2) (1-3)

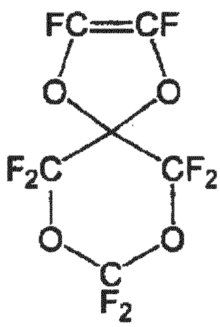
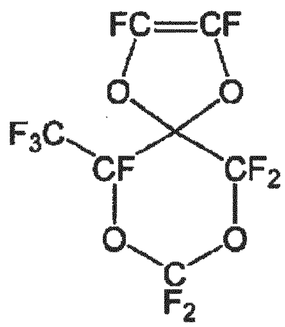

(1-4) (1-5)

In the formula (2), $Y^1$ and $Y^2$ are preferably each independently a fluorine atom, a $C_{1-4}$ perfluoroalkyl group or a $C_{1-4}$ perfluoroalkoxy group, particularly preferably a fluorine atom or a trifluoromethyl group.

As specific examples of preferred compound (2), compounds (2-1) and (2-2) may be mentioned.

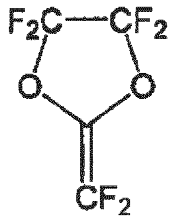 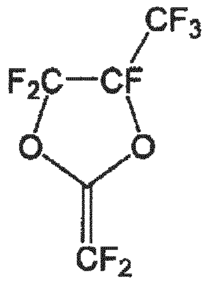

(2-1) (2-2)

The polymer (21) may be a homopolymer of the above-described fluorinated cyclic monoene, or may be a copolymer with other monomer copolymerizable with the fluorinated cyclic monoene.

Here, the content of the units derived from the fluorinated cyclic monoene to all units in the polymer (21) is preferably 20 mol% or more, more preferably 40 mol% or more, further preferably 100 mol%.

As other monomer copolymerizable with the fluorinated cyclic monoene, for example, a fluorinated diene, a monomer having a reactive functional group in its side chain, tetrafluoroethylene, chlorotrifluoroethylene or a perfluoroalkyl vinyl ether may, for example, be mentioned.

The fluorinated diene may be one as explained for the after-described polymer (22). The monomer having a reactive functional group in its side chain may be a monomer having a polymerizable double bond and a reactive functional group. The polymerizable double bond may, for example, be $CF_2$=CF-, $CF_2$=CH-, $CH_2$=CF-, CFH=CF-, CFH=CH-, $CF_2$=C- or CF=CF-. The reactive functional group may be one as explained for the after-described polymer (22).

A polymer obtained by copolymerization of the fluorinated cyclic monoene and the fluorinated diene is taken as a polymer (21).

Polymer (22):

A "fluorinated diene" is a cyclopolymerizable fluorinated monomer having two polymerizable double bonds and a fluorine atom. The polymerizable double bond is preferably a vinyl group, an allyl group, an acryloyl group or a methacryloyl group. The fluorinated diene is preferably the following compound (3).

$CF_2$=CF-Q-CF=$CF_2$ (3)

In the formula (3), Q is a $C_{1-5}$, preferably $C_{1-3}$ perfluoroalkylene group which may be branched, which may contain an etheric oxygen atom, and in which one or more of fluorine atoms may be replaced with a halogen atom other than a fluorine atom. The halogen atom other than a fluorine atom may, for example, be a chlorine atom or a bromine atom.

Q is preferably a perfluoroalkylene group containing an etheric oxygen atom. In such a case, the etheric oxygen atom in the perfluoroalkylene group may be present on one terminal of the perfluoroalkylene group, may be present on both terminals of the perfluoroalkylene group, or may be present between carbon atoms of the perfluoroalkylene group. In view of cyclopolymerizability, the etheric oxygen atom is present preferably on one terminal of the perfluoroalkylene group.

As specific examples of the compound (3), the following compounds may be mentioned.

$CF_2$=$CFOCF_2CF$=$CF_2$,

$CF_2$=CFOCF($CF_3$)CF=$CF_2$,

$CF_2$=$CFOCF_2CF_2CF$=$CF_2$,

$CF_2$=$CFOCF_2$CF($CF_3$)CF=$CF_2$,

$CF_2$=CFOCF($CF_3$)$CF_2$CF=$CF_2$,

$CF_2$=CFOCFCl$CF_2$CF=$CF_2$,

$CF_2=CFOCCl_2CF_2CF=CF_2$,

$CF_2=CFOCF_2OCF=CF_2$,

$CF_2=CFOC(CF_3)_2OCF=CF_2$,

$CF_2=CFOCF_2CF(OCF_3)CF=CF_2$,

$CF_2=CFCF_2CF=CF_2$,

$CF_2=CFCF_2CF_2CF=CF_2$,

$CF_2=CFCF_2OCF_2CF=CF_2$.

As the units formed by cyclopolymerization of the compound (3), the following units (3-1) to (3-4) may be mentioned.

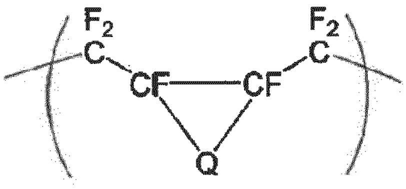

(3−1)

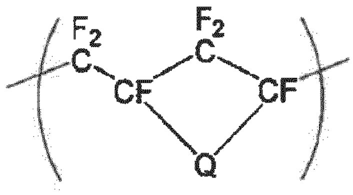

(3−2)

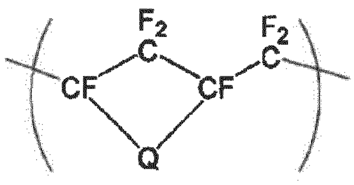

(3−3)

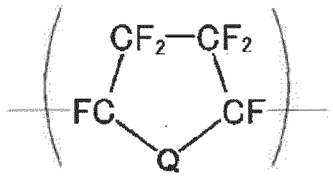

(3−4)

The polymer (22) may be a homopolymer of the fluorinated diene, or may be a copolymer with other monomer copolymerizable with the fluorinated diene.

As other monomer copolymerizable with the fluorinated diene, for example, a monomer having a reactive functional group in its side chain, tetrafluoroethylene, chlorotrifluoroethylene or a perfluoro(methyl vinyl ether) may be mentioned.

As specific examples of the polymer (22), for example, a polymer having units represented by the following formula (3-1-1), obtained by cyclopolymerization of $CF_2=CFOCF_2CF_2CF=CF_2$ (perfluoro(3-butenyl vinyl ether)) may be mentioned.

Hereinafter, perfluoro(3-butenyl vinyl ether) will be referred to as "BVE".

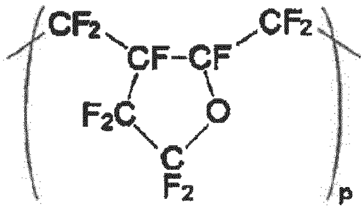

(3−1−1)

In the formula (3-1-1), p is an integer of from 5 to 1,000.

p is preferably an integer of from 10 to 800, particularly preferably from 10 to 500.

The polymer (2) may be a synthetic product or may be a commercial product.

As specific examples of the polymer (2), a BVE cyclic polymer (manufactured by AGC Inc., CYTOP (registered trademark)), a tetrafluoroethylene/perfluoro(4-methoxy-1,3-dioxol) copolymer (manufactured by Solvay, Hyflon (registered trademark) AD), a tetrafluoroethylene/perfluoro(2,2-dimethyl-1,3-dioxol) copolymer (manufactured by Dupont, Teflon (registered trademark) AF), and a perfluoro(4-methyl-2-methylene-1,3-dioxolane) polymer (MMD polymer) are preferred.

(Terminal structure of fluorinated polymer)

The fluorinated polymer is obtained usually by polymerizing the above monomers by radical polymerization using a radical polymerization initiator. In such a case, the fluorinated polymer at the time of completion of the polymerization is considered to have a structure having fragments of the radical polymerization initiator used for the polymerization added, as the structure at the terminal of the molecular chain (main chain). Further, in a case where a chain transfer agent is used for polymerization, the structure at the terminal of the molecular chain (main chain) may be a structure having fragments of the chain transfer agent added.

Of the fluorinated polymer, the above terminal structure may be converted to other structure. For example, by subjecting the fluorinated polymer at the time of completion of the polymerization to heat treatment at 250°C or higher, the structure at the terminal of the main chain becomes -C(=O)-F, and the fluorinated polymer becomes an acid fluoride.

By subjecting the acid fluoride to methanol treatment, the structure at the terminal of the main chain becomes a methyl ester group. The acid fluoride with high reactivity may be converted into a methyl ester group by simple methanol treatment. Thus, the stability of the obtainable fluorinated polymer is likely to be improved, such being favorable.

Further, by subjecting the acid fluoride to fluorination treatment, the structure at the terminal of the main chain becomes a trifluoromethyl group. As the fluorination treatment, for example, treatment method disclosed in JP-A-H11-152310, paragraph [0040] may be mentioned. The trifluoromethyl group has high heat resistance and is likely to improve heat resistance of the obtainable fluorinated polymer, and is thereby preferred. Further, when the fluorinated polymer has a trifluoromethyl group at its terminal, the surface energy of the obtained resin film tends to be low, and a metal film can hardly be formed on the surface of a film formed of the fluorinated polymer as a material, and pattering will readily be conducted.

The fluorinated polymer preferably has, as the structure at the terminal of the main chain, a methyl ester group or a trifluoromethyl group, whereby intermolecular interaction at the terminal of the main chain tends to be small, and deposition will readily be conducted.

The above-described structure at the terminal of the main chain can be confirmed by infrared spectroscopy.

(Molecular weight of fluorinated polymer)

It is difficult to measure the molecular weight of a fluorinated polymer having high crystallinity since it is hardly soluble in a solvent, whereas the molecular weight of an amorphous fluorinated polymer, which is highly soluble in a fluorinated solvent, can be measured by gel permeation chromatography (GPC) or the like.

The weight average molecular weight (hereinafter referred to as "Mw") of the fluorinated polymer is preferably from 1,000 to 20,000, more preferably from 1,500 to 15,000, further preferably from 2,000 to 10,000.

If the weight average molecular weight is lower than 1,000, the fluororesin has a low softening temperature, and the shape of a film formed of the fluorinated polymer may not be kept at a process temperature in element preparation or under element use conditions.

If the weight average molecular weight is higher than 20,000, the main chain of the fluorinated polymer will be cleaved at the time of deposition and the fluorinated polymer will have a lower molecular weight, and thus the strength of the layer to be formed tends to be insufficient, and further, defects due to decomposed products will occur, and thus no smooth surface is likely to be obtained. Further, possibility that molecules or ions generated by cleavage of the main chain will be unintentionally included and will affect electrically conductivity of the electrically conductive film adjacent to the resin film formed of the fluorinated polymer, is considered. Further, when the fluorinated polymer according to the present embodiment is used to prepare a resin film, which is used to conduct patterning of an electrically conductive film as described hereinafter, the life of an element having the electrically conductive film (for example light-emitting life of an organic EL element) may be shortened.

Accordingly, when Mw of the fluorinated polymer is within a range of from 1,000 to 20,000, the main chain of the fluorinated polymer will not be cleaved, and a layer having sufficient strength and a smooth surface can be formed.

The weight average molecular weight of the fluorinated polymer is a value measured by gel permeation chromatography (GPC). First, a PMMA reference sample having a known molecular weight is subjected to GPC, and a

calibration curve is prepared from the elution time of the peak top and the molecular weight. Then, the fluorinated polymer is subjected to GPC, and Mw and Mn are obtained from the calibration curve. As a mobile phase solvent, a solvent mixture of 1,1,1,2,3,4,4,5,5,5-decafluoro-3-methoxy-2-(trifluoromethyl)pentane/hexafluoroisopropyl alcohol (volume ratio 85/15) is used.

The "molecular weight distribution" is the ratio of Mw to the number average molecular weight (hereinafter referred to as "Mn"), that is Mw/Mn. From the viewpoint of stability of the quality of the layer to be formed, the molecular weight distribution (Mw/Mn) of the fluorinated polymer is preferably smaller, and is preferably 2 or less. The molecular weight distribution of the fluorinated polymer is preferably 1.5 or less, further preferably 1.2 or less. The theoretical lower limit of the molecular weight distribution is 1.

The smaller the molecular weight distribution of the fluorinated polymer is, the smaller the variation of the deposition conditions tends to be, and the more a phase separated structure homogeneous in the film thickness direction is likely to be formed.

As a method of obtaining a fluorinated polymer with a small molecular weight distribution, molecular weight adjustment by controlled polymerization such as living radial polymerization, or a molecular weight fractionation method by sublimation purification or supercritical extraction, or by size exclusion chromatography, may be mentioned.

In this specification, the weight average molecular weight and the molecular weight distribution are values measured by gel permeation chromatography (GPC).

(Surface energy of resin film)

The fluorinated polymer is preferably such that a resin film formed of the fluorinated polymer as a material has a surface energy of 30 mN/m or less, more preferably 25 mN/m or less, further preferably 20 mN/m or less. When the resin film has such a surface energy, when a metal material is subjected to dry coating, the metal material will hardly be attached to the surface of the resin film, and patterning will readily be conducted.

The surface energy of the resin film may be adjusted by changing the fluorine atom content or the content of the trifluoromethyl moiety in the fluorinated polymer to be used. By increasing the fluorine atom content or the content of the trifluoromethyl moiety in the fluorinated polymer, the surface energy of the resin film tends to be small.

(Resin film)

Figs. 2 and 3 are views illustrating the resin film according to the present embodiment, more particularly, views illustrating an electrically conductive film produced by using the resin film. Fig. 2 is a plan view illustrating an electrically conductive film 1 having the resin film, and Fig. 3 is a schematic arrow view at segment III-III in Fig. 2.

As shown in Figs. 2 and 3, the electrically conductive film 1 has a first film 10, a resin film 15 according to the present embodiment, and a second film 20.

The electrically conductive film 1 is provided on a substrate 50. The substrate 50 is an object on which the electrically conductive film 1 is to be formed. The substrate 50 has light transparency.

The second film 20 is formed on the substrate 50, and the first film 10 is formed on the second film 20. The resin film 15 is formed between the first film 10 and the second film 20. That is, on the substrate 50, the first film 10, the resin film 15 and the second film 20 are laminated in this order.

(First film)

The first film 10 is a metal film formed of a first electrically conductive material as a material. The first electrically conductive material as a material of the first film 10 may be a metal such as silver (Ag), gold (Au), copper (Cu), aluminum (Al), magnesium (Mg), magnesium silver (MgAg) or ytterbium silver (YbAg), or an electrically conductive oxide such as indium tin oxide (ITO), indium zinc oxide (IZO) or zinc oxide (ZnO).

The first film 10 has a the first region 10A and a second region 10B having a light transmittance higher than the first region 10A. In the electrically conductive film 1, in the first region 10A, the electrically conductive film 11 is located, and in the second region 10B, the electrically conductive film 12 is located. The electrically conductive film 11 and the electrically conductive film 12 unitedly constitute the first film 10.

As shown in Fig. 2, in the electrically conductive film 1, a plurality of the second regions 10B, that is a plurality of the electrically conductive films 12 are arranged in a matrix, and on the other portion, the electrically conductive film 1 has the first region 10A formed in a lattice form, that is the electrically conductive film 11 in a lattice form. In Fig. 2, the second region 10B is rectangular in a plan view, however, the form is not limited thereto, and various plan-viewed shapes depending upon the design may be employed.

The lower surface 11a of the electrically conductive film 11 is in contact with the second film 20. Further, the side surface 11b of the electrically conductive film 11 is in contact with the resin film 15.

The lower surface 12a of the electrically conductive film 12 is in contact with the resin film 15.

The electrically conductive film 12 is thinner than the electrically conductive film 11. For example, the thickness of the electrically conductive film 11 is from 10 nm to 1,000 nm, and the thickness of the electrically conductive film 12 is from 0 nm to 50 nm. An electrically conductive film 11 formed to be so thin as 50 nm or less, has light transparency.

The electrically conductive film 11 is formed to be thicker than the electrically conductive film 12, so as to secure the electrical conductivity of the entire electrically conductive film 1. The electrically conductive film 11 may have light transparency or may not have light transparency so long as the required electrical conductivity is secured.

(Second film)

The second film 20 is formed on the surface 50a of the substrate 50. The second film 20 is a metal film formed of a second electrically conductive material as a material. The second electrically conductive material as a material of the second film 20 may be the same materials which can be used as the first electrically conductive material.

The first electrically conductive material as a material of the first film 10 and the second electrically conductive material as a material of the second film 20 may be the same or different. In order to suppress contact resistance at the interface between the first film 10 and the second film 20, the first electrically conductive material and the second electrically conductive material are preferably the same.

The second film 20 has light transparency. The second film 20 has a light transmittance higher than the electrically conductive film 11. The thickness of the second film 20 is from 5 nm to 60 nm.

Further, the second film 20 two-dimensionally overlaps with the electrically conductive film 12. Accordingly, the thickness of the second film 20 and the total thickness of the second film 20 and the electrically conductive film 12 are properly adjusted so that the second region 10B has light transparency.

It is possible to use only the second film 20 as a transparent electrode to be used for a photoelectronic element such as a light-emitting element or a light-receiving element. Whereas, the second film 20 formed so thin as having light transparency has high wire resistance.

Whereas, the electrically conductive film 1 has the second film 20 and the first film 10 laminated. Accordingly, at a position corresponding to the first region 10A, the electrically conductive film 11 and the second film 20 are laminated to be thick. Thus, the electrically conductive film 1 as a whole has low resistance while light transparency is secured at a portion corresponding to the second region 10B.

(Resin film)

The resin film 15 is formed of the above-described fluorinated polymer according to the present embodiment as a material. The resin film 15 is disposed to overlap with the second region 10B. The resin film 15 is used, as described in the after-described method for producing an electrically conductive film, to conduct pattering of the first region 10A and the second region 10B of the first film 10 by dry coating.

The fluorinated polymer as a material of the resin film 15 has low absorbance and has a low refractive index and thereby has small light absorption within a wavelength range including a near infrared region, and is excellent in optical properties. Accordingly, the resin film 15 will not impair light transparency of the second region 10B even though it overlaps the second region 10B having light transparency.

The above-described fluorinated polymer according to the present embodiment has physical properties suitable for the after-described production method. Accordingly, by using the fluorinated polymer according to the present embodiment, a favorably patterned electrically conductive film 1 can be produced.

(Method for producing electrically conductive film)

Figs. 4 to 6 are schematic views illustrating a method for producing the above-described electrically conductive film 1. As described hereinafter, by the resin film formed of the fluorinated polymer as a material, the electrically conductive film 1 having desired physical properties can readily be produced.

First, as shown in Fig. 4, the second electrically conductive material is formed on the surface of the substrate 50 to obtain the second film 20. The second film 20 may be formed, for example, by dry coating method such as deposition, sputtering, CVD (chemical vapor deposition) or ALD (atomic layer deposition). The second film 20 corresponds to the "primary layer" in the present invention.

Then, as shown in Fig. 5, on the surface 20a of the second film 20, the fluorinated polymer P according to the present embodiment is deposited via a mask M under reduced pressure. The mask M has openings M2 arranged in a matrix and a shielding portion M1 provided in a lattice form.

Deposition of the fluorinated polymer P is conducted, for example, by heating the fluorinated polymer under a pressure of $1\times10^{-3}$ Pa.

The fluorinated polymer P reaches the surface 20a of the second film 20 through the openings M2 of the mask M and is shielded by the shielding portion M1 of the mask M, whereby a resin film 15 formed of the fluorinated polymer P as a material is formed.

The resin film 15 is arranged in a matrix on the surface 20a. Further, at a portion where no resin film 15 is formed, the second film 20 is exposed in a lattice form.

Then, as shown in Fig. 6, over the resin film 15, the first electrically conductive material 10X is applied by dry coating. As dry coating, deposition, sputtering or ALD (atomic layer deposition) may, for example, be employed.

The first electrically conductive material 10X is less likely to be attached to the surface of the resin film 15 formed of the fluorinated polymer as a material, and is likely to be attached to the surface of the second film 20 formed of the second electrically conductive material as a material. Accordingly, by applying the first electrically conductive material 10X over the entire surface from above the substrate 50 without using a mask, the first electrically conductive material 10X is formed relatively thick on the surface of the second film 20, and the first electrically conductive material 10X is formed relatively thin on the surface of the resin film 15. In other words, by applying the first electrically conductive material 10X by dry coating entirely from above the substrate 50, the first electrically conductive material 10X is patterned between a portion where the resin film 15 is formed and a portion where no resin film 15 is formed.

In such a manner, on the surface of the second film 20, an electrically conductive film 11 in a lattice form is formed. Further, at a position corresponding to the resin film 15, an electrically conductive film 12 is formed in a matrix. The electrically conductive film 11 and the electrically conductive film 12 constitute the first film 10.

In such a manner, the electrically conductive film 1 is obtained. The position where the electrically conductive film 11 is formed corresponds to the first region 10A. The position where the electrically conductive film 12 is formed corresponds to the second region 10B.

If the electrically conductive film 11 is to be directly produced by deposition via a mask, it is necessary to use a mask having a shielding portion in a matrix. Such a mask is required to have a holding portion to hold the shielding portion, and at a portion shieled by the holding portion, the electrically conductive film 11 will not be formed, and the thickness of the obtainable electrically conductive film 11 tends to be non-uniform. Otherwise, formation of the electrically conductive film 11 in a lattice form by conducting deposition dividedly several times using a stripe mask may be considered, however, positioning of the mask tends to be difficult, and operation tends to be troublesome.

Further, in a case where the mask is made of a metal, when the electrically conductive film 11 is to be produced by deposition, the first electrically conductive material 10X to be deposited will be gradually attached to the metal mask, thus changing the size of the opening of the mask. In such a case, the first electrically conductive material 10X attached to the metal mask should be cleaned off or the mask should be changed to a new one, and troublesome work and a tremendous cost will be required.

On the other hand, in the above production method, as shown in Fig. 6, the resin film 15 is formed of the fluorinated polymer P as a material, and on the entire resin film 15, the first electrically conductive material 10X is deposited, whereby a first film 10 having the electrically conductive film 11 and the electrically conductive film 12 naturally patterned is obtained. The resin film 15 can be precisely formed by deposition via a mask. Thus, according to the method for producing an electrically conductive film, a precisely patterned electrically conductive film can readily be produced.

The fluorinated polymer of the above structure is suitable for deposition, and can be suitably used for metal patterning.

According to the resin film of the above structure, metal pattering is favorably conducted.

[Second embodiment]

Fig. 7 is a schematic cross sectional view illustrating a photoelectronic element (organic EL element) 100 according to a second embodiment of the present invention. The organic EL element 100 has a structure having a substrate 110, an anode 111, a partition wall 112, a functional layer 113 and a cathode 115 laminated in this order. The functional layer 113 contains a light emitting layer.

The organic EL element 100 according to the present embodiment employs top emission system in which light L generated in the functional layer 113 is taken to the outside via the cathode 115.

(Substrate)

The substrate 110 may have optical transparency or may not have optical transparency. The material forming the substrate 110 may be an inorganic material such as glass, quartz glass or silicon nitride, or an organic polymer (resin) such as a polyimide resin, an acrylic resin or a polycarbonate resin. Further, so long as the electrical insulating property of the surface is secured, the material forming the substrate 110 may be a metal material.

Further, the substrate 110 has various wires and drive elements electrically connected to the organic EL element, which are not shown.

(Anode)

The anode 111 is formed on the substrate 110 and supplies holes to the functional layer 113. Further, the anode 111 has light reflectivity which reflects light emitted from the light emitting layer contained in the functional layer 113.
As the material forming the anode 111, an electrically conductive metal oxide such as ITO (indium tin oxide: indium doped tin oxide) or IZO (indium zinc oxide: indium doped zinc oxide) may be used. Further, in order to impart light reflectivity to the anode 111, on the substrate 110 side of the anode 111 or on the functional layer 113 side of the anode 111, a reflective film formed of a metal material is provided. That is, the anode 111 has a laminated structure of a layer formed of an electrically conductive metal oxide and a reflective film.
Further, as the material forming the anode 111, silver may also be used.
The thickness of the anode 111 is not particularly limited and is preferably from 30 to 300 nm. The thickness of the anode 111 is, for example, 100 nm.

(Partition wall)

The partition wall 112 partially overlaps with the periphery of the anode 111 and is formed, for example, in a lattice form. In the openings of the partition wall 112, the functional layer 113 is formed to partition the organic EL element 100.
The partition wall 112 is formed, for example, by a polyimide as a material.

(Functional layer)

The functional layer 113 is formed to overlap with the anode 111. The functional layer 113 has a light emitting layer. In the light emitting layer, holes injected from the anode 111 and electrons injected from the cathode 115 are recombined to emit light by emitting photons. The emission wavelength at that time is determined depending on the material for forming the light emitting layer. The light emitting layer corresponds to the "active layer" in the present invention.
The light emitting layer may be formed by using a material known as a material of a light emitting layer of an organic EL element.
The material for forming the light emitting layer may be used alone or may be used in combination of two or more, and it is suitably selected depending on the desired light emission wavelength.
The functional layer 113 may have a hole injection layer and a hole transport layer between the light emitting layer and the anode 111.
The hole injection layer has a function to facilitate injection of holes from the anode to the hole transport layer.
The hole transport layer has a function to favorably transport holes injected from the anode 111 toward the light emitting layer.
Further, the functional layer 113 may have an electron transport layer and an electron injection layer between the light emitting layer and the cathode 115.
The electron transport layer has a function to favorably transport electrons injected from the cathode 115 toward the light emitting layer.
The electron injection layer has a function to facilitate injection of electrons from the cathode 115 to the electron transport layer.

(Cathode)

The cathode 115 is formed to entirely cover the partition wall 112 and the functional layer 113. The cathode 115 has a function to inject electrons to the functional layer.
In the photoelectronic element according to the present embodiment, the cathode 115 contains the resin film of the present invention and is patterned. The cathode 115 has a first film 116, a resin film 117 and a second film 118.
The second film 118 is formed to cover the partition wall 112 and the functional layer 113. As the constitution and the material of the second film 118, the constitution and the material described for the second film 20 according to the first embodiment can be employed.
The resin film 117 two-dimensionally overlaps with the functional layer 113 and is formed on the upper surface 118a of the second film 118. As the constitution and the material of the resin film 117, the fluorinated polymer according to the present embodiment, in the same manner as the resin film 15 of the first embodiment, can be employed.
The first film 116 is formed to two-dimensionally overlap with the partition wall 112. As the constitution and the material of the first film 116, the constitution and the material described for the first film 10 according to the first embodiment may be employed.

That is, the first region of the cathode 115 overlaps with the partition wall 112, and the second region of the cathode 115 overlaps with the functional layer 113 including the light emitting layer.

(Microcavity structure)

In the organic EL element 100 of the present embodiment, the anode 111 and the cathode 115 constitute a light resonator structure (microcavity) that resonates light between the anode 111 and the cathode 115, that is between an upper surface of the reflective film of the anode 111 and a lower surface of the second film 118. Between the anode 111 and the cathode 115, light generated in the light emitting layer is repeatedly reflected, and light having a wavelength that matches the optical path length between the anode 111 and the cathode 115 is resonated and amplified. On the other hand, light having a wavelength that does not match the optical path length between the anode 111 and the cathode 115 is attenuated.

Here, the "optical path length" shall be calculated by using the desired wavelength of light emitted to the outside of the element and the refractive index of each layer at the desired wavelength of the light.

The optical path length between the anode 111 and the cathode 115 is, for example, set to be an integral multiple of the center wavelength of the light L generated by the light emitting layer contained in the functional layer 113. In that case, the light L emitted by the light emitting layer will be emitted to the outside of the organic EL element 100 as amplified as it is closer to the center wavelength, or as attenuated as it departs from the center wavelength. In this way, the light L emitted from the organic EL element 100, becomes to be one, of which the half value width of the light emission spectrum is narrow, and the color purity is improved.

In the organic EL element 100 of such a constitution which has, as the resin film 117, a resin layer formed of the fluorinated polymer in the present invention as a material, patterning on a metal (the first film 116) is favorably conducted in the second region. Accordingly, it is possible to reduce the wire resistance of the cathode 115 while a high light extraction efficiency is maintained in the second region, and favorable drive can be realized.

In the above embodiment, the organic EL element is exemplified as a photoelectronic element, however, the photoelectronic element to which the resin film according to an embodiment of the present invention is applied is not limited to an organic EL element.

The photoelectronic element according to an embodiment of the present invention may, for example, be a semiconductor laser. The semiconductor laser may be one having a known constitution. By patterning the electrically conductive film, using the resin film, on the cathode which the semiconductor laser has, the cathode is made to have low resistance, and a semiconductor laser having an improved output can be obtained.

Further, the photoelectronic element according to an embodiment of the present invention may be a light-receiving element such as an optical sensor or a solar cell. As the optical sensor and the solar cell, a kwon constitution such that holes and electrons generated in an active layer (light-receiving layer) depending on the intensity of light received by the active layer are transmitted to the cathode and the anode via the semiconductor layer, may be employed.

By patterning the electrically conductive film on the electrode (anode, cathode) of the optical sensor or the solar cell using the resin film, the optical sensor has improved detection performance, or the solar cell has improved power generation efficiency.

Further, in the photoelectronic element according to an embodiment of the present invention, by using the resin film, metal patterning can favorably be conducted, whereby the entire element has high transmittance, and thus the photoelectronic element is useful for an application to e.g. a transparent display. Further, e.g. in an under-display camera or an under-display sensor, it is required to increase the transmittance of the display on the camera or the sensor, and patterning using the resin film of the present invention is very useful.

That is, the fluorinated polymer of the present invention, which has excellent light transparency, is suitably applicable to the photoelectronic element.

Further, the resin film of the present invention can be used for forming a patterned electrode or wiring, in addition to the photoelectronic element.

The preferred embodiments of the present invention are described above with reference to drawings. However, the present invention is by no means restricted to such examples. Various forms, combinations, etc. of the respective constituents indicated above are merely examples, and various changes are possible in accordance with requirements in design, etc., within the scope of the present invention.

EXAMPLES

Now, the present invention will be described in further detail with reference to Examples. However, it should be understood that the present invention is by no means restricted to such specific Examples.

<Evaluation methods>

In the present embodiment, evaluation was made by the following methods.

[Measurement of thermogravimetric loss rate of fluorinated polymer in vacuum]

Measurement was conducted by using a vacuum differential thermobalance (manufactured by ADVANCE RIKO, Inc.:VPE-9000). 50 mg of the fluorinated polymer was put in a cell having an inner diameter of 7 mm, and the weight loss rate (%) of the fluorinated polymer when the temperature was increased from room temperature to 500°C at a rate of 2°C per minute in a degree of vacuum of $1\times10^{-3}$ Pa, to the initial weight (50 mg), was measured.
A temperature ($T_{d100}$) at which the weight loss rate became 100%, a temperature ($T_{d10}$) at which the weight loss rate became 10%, and a temperature ($T_{d90}$) at which the weight loss rate became 90%, were obtained.

[Measurement of melting point]

Measurement was conducted by using a differential scanning calorimeter (manufactured by NETZSCH, DSC 204 F1 Phoenix). 9 mg of the fluorinated polymer was put in a sample container, the heat capacity when the temperature was increased from -70°C to 350°C at a rate of 10°C per minute was measured, and the melting point was determined from the obtained melting peak.

(Measurement of $CF_3$ concentration)

The content (mmol/g) of the trifluoromethyl moiety was obtained in accordance with the following formula.

$$(\text{Content of trifluoromethyl moiety})=[NCF_3/MA]\times1{,}000$$

$NCF_3$: the sum of products of the number of moles of the trifluoromethyl moiety constituting each type of units constituting the fluorinated polymer, and the mole fraction of the units to all units.
MA: the sum of products of the total atomic weight of all atoms constituting each type of units constituting the fluorinated polymer, and the mole fraction of the units to all units.

The above number of moles of the trifluoromethyl moiety, total atomic weight of all atoms constituting each type of units, mole fraction, etc. used for the above formula, were calculated by the mole fraction of the constituting units and the amount of terminals of the fluorinated polymer, obtained by subjecting the fluorinated polymer to NMR analysis and IR analysis.

(Measurement of fluorine atom content)

The fluorine atom content (mass%) was obtained in accordance with the following formula.

$$(\text{Fluorine atom content})=[19\times NF/MA]\times100$$

NF: the sum of products of the total atomic weight of fluorine atoms constituting each type of units constituting the fluorinated polymer, and the mole fraction of the units to all units.
MA: the sum of products of the total atomic weight of all atoms constituting each type of units constituting the fluorinated polymer, and the mole fraction of the units to all units.
The above atomic weight of fluorine atoms, total atomic weight of all atoms constituting each type of units, mole fraction, etc., used for the above formula, were calculated by the mole fraction of the constituting units and the amount of terminals of the fluorinated polymer, obtained by subjecting the fluorinated polymer to NMR analysis and IR analysis.

<Synthesis of fluorinated polymer>

The fluorinated polymer used for evaluation was synthesized as follows.

[Synthesis Example 1]

Into a stainless steel autoclave having an internal capacity of 1,006 mL, 152.9 g of PPVE, 805 g of AC2000 (manufactured by AGC Inc.), 2.40 g of methanol and 1.15 g of azobisisobutyronitrile (AIBN) were put, and the autoclave was freeze-deaerated with liquid nitrogen.
The temperature of the autoclave was increased to 70°C, and 56.3 g of TFE was introduced into the autoclave to initiate polymerization. Since the pressure in the autoclave decreased as the polymerization proceeded, TFE was continuously supplied to conduct polymerization while the temperature and the pressure in the autoclave were kept constant. 5 hours after initiation of the polymerization, the autoclave was cooled to terminate the polymerization, and the gas in the system was discharged to obtain a reaction solution.
800 g of methanol was added to the reaction solution and mixed to precipitate the polymer dissolved in the reaction solution, followed by phase separation, and the lower layer in which the polymer was dispersed was recovered. The obtained polymer dispersion was warm air-dried at 80°C for 16 hours and then vacuum dried at 100°C for 16 hours to obtain a polymer.
The composition of the obtained polymer was PPVE units:TFE units=14:86 (mol%).
Then, the obtained polymer was heated in an oven at 330°C, dipped in methanol and heated in an oven at 75°C for 40 hours to replace the terminal group with a methyl ester group to obtain fluorinated polymer C.
The obtained fluorinated polymer C was put in a raw material charge portion of a glass tube type sublimation purification apparatus, and the pressure in the interior of collecting portions was reduced to $3.0 \times 10^{-3}$ Pa. The raw material charge portion was gradually heated to 330°C to sublimate the fluorinated polymer C. In the sublimation purification apparatus, the collecting portions, from the side closer to the charge portion, were heated at set temperatures of 310°C, 280°C, 250°C and 200°C.
Among such collecting portions, substances precipitated in the collecting portion at the set temperature of 280°C were recovered to obtain 2 g of purified fluorinated polymer C1.

[Synthesis Example 2]

A jacketed polymerization vessel (made of stainless steel) having an internal capacity of 1.351 L was deaerated, and into the polymerization vessel, 433 g of AE-3000 (manufactured by AGC Inc.), 360 g of PPVE, 120 g of TFE and 15 g of methanol weighed were put. While the temperature was kept at 60°C, 15 mL of a 3.33 mass% solution (solvent: AE-3000) of t-butyl peroxypivalate (PBPV) was charged to initiate polymerization. During the polymerization, TFE was introduced into the polymerization vessel so as to keep the polymerization pressure to be 1.00 MPa by the gauge pressure.
Since the polymerization pressure decreased accompanying the progress of the polymerization, TFE was continuously supplied so that the polymerization pressure would be substantially constant. The polymerization was terminated at a point when the amount of TFE introduced reached 121 g to obtain a fluorinated polymer.
Then, the obtained polymer was heated in an oven at 300°C, dipped in methanol and heated in an oven at 75°C for 40 hours to replace the terminal group with a methyl ester group to obtain fluorinated polymer X.
The composition of the obtained polymer X was PPVE units:TFE units=12:88 (mol%).
In the same manner as in Synthesis Example 1, the fluorinated polymer X was sublimated. The collecting portions, from the side closer to the charge portion, were heated at set temperatures of 310°C, 280°C, 220°C and 160°C, and substances precipitated in the collecting portions at set temperatures of 220°C and 280°C were recovered to obtain 2 g of purified fluorinated polymer X1.

[Synthesis Example 3]

In the same manner as in Synthesis Example 1 except that 78.9 g of PPVE, 767 g of AC2000, 4.23 g of methanol, 1.27 g of AIBN and 48.4 g of TFE were used, a polymer was obtained.
The composition of the obtained polymer was PPVE units:TFE units=9:91 (mol%).
Then, in the same manner as in Synthesis Example 1, the terminal group of the polymer was replaced with a methyl ester group to obtain fluorinated polymer D.
In the same manner as in Synthesis Example 1, the fluorinated polymer D was sublimated. Substances precipitated in the collection portions at set temperatures of 250°C and 280°C were recovered to obtain 4 g of fluorinated polymer D1.

[Synthesis Example 4]

In the same manner as in Synthesis Example 1 except that 57.9 g of PPVE, 4.13 g of methanol and 1.24 g of AIBN were used, polymer was obtained.

The composition of the obtained polymer was PPVE units:TFE units=6:94 (mol%).

Then, in the same manner as in Synthesis Example 1, the terminal group of the polymer was replaced with a methyl ester group to obtain fluorinated polymer E.

In the same manner as in Synthesis Example 1, the fluorinated polymer E was sublimated. Substances precipitated in the collection portions at set temperatures of 200°C, 250°C and 280°C were recovered to obtain 5 g of purified fluorinated polymer E1.

[Synthesis Example 5]

A jacketed polymerization vessel (made of stainless steel) having an internal capacity of 1.351 L was deaerated, and into the polymerization vessel, 649 g of AE-3000, 152 g of PPVE, 109 g of TFE and 15.5 g of methanol weighed were put.

While the temperature of the polymerization vessel was kept at 60°C, 18.9 mL of a 0.79 mass% solution (solvent: AE-3000) of t-butyl peroxypivalate (PBPV) was charged to initiate polymerization.

During the polymerization, since the polymerization pressure decreased as the polymerization proceeded, TFE was continuously supplied to the polymerization vessel so that the polymerization pressure would be substantially constant. The polymerization pressure was kept under 1.04±0.04 MPaG (gauge pressure).

The polymerization was terminated at a point when the amount of TFE introduced reached 121 g to obtain polymer.

The composition of the obtained polymer was PPVE units:TFE units=4:96 (mol%).

The terminal group of the obtained polymer was replaced with a methyl ester group under the same conditions as in Synthesis Example 1 to obtain fluorinated polymer G.

In the same manner as in Synthesis Example 1, the fluorinated polymer G was sublimated. Substances precipitated in the collection portion at a set temperature of 250°C were recovered to obtain 4 g of purified fluorinated polymer G1.

[Synthesis Example 6]

In the same manner as in Synthesis Example 5 except that 701 g of AE-3000, 57g of PPVE, 108 g of TFE, 35.7 g of methanol and 18.9 mL of a 0.53 mass% solution (solvent: AE-3000) of PBPV were used, polymer was obtained.

The composition of the obtained fluorinated polymer was PPVE units:TFE units=2:98 (mol%).

The terminal group of the obtained polymer was replaced with a methyl ester group under the same conditions as in Synthesis Example 1 to obtain fluorinated polymer I.

In the same manner as in Synthesis Example 1, the fluorinated polymer I was sublimated. Substances precipitated in the collection portions at set temperatures of 250°C and 280°C were recovered to obtain 4 g of purified fluorinated polymer I1.

[Synthesis Example 7]

A jacketed polymerization vessel (made of stainless steel) having an internal capacity of 1.351 L was deaerated, and into the polymerization vessel, 331 g of R113 (1,1,2-trifluorotrichloroethane, manufactured by AGC Inc.), 1.1 g of methanol and 765 g (5.1 mol) of HFP were charged, and then TFE was charged. TFE was charged so that the pressure would be 0.62 MPaG at a temperature of the polymerization vessel of 50°C.

Then, a 0.3 mass% solution (solvent: R113) of PEROYL FB was charged to initiate polymerization. Since the polymerization pressure decreased as the polymerization proceeded, TFE was continuously supplied so that the polymerization pressure would be substantially constant. A 0.3 mass% solution (solvent: R113) of PEROYL FB was intermittently charged, and at a point when 71 g (0.71 mol) of TFE was consumed, polymerization was terminated to obtain fluorinated copolymer.

The composition of the obtained polymer was HFP units:TFE units=20:80 (mol%).

Then, the obtained polymer was heated in an oven at 330°C, dipped in methanol and heated in an oven at 75°C for 40 hours to replace the terminal group with a methyl ester group to obtain fluorinated polymer Y.

In the same manner as in Synthesis Example 2, the fluorinated polymer Y was sublimated. Substances precipitated in the collection portions at set temperatures of 160°C, 220°C, 280°C and 310°C were recovered to obtain 4 g of purified fluorinated polymer Y1.

[Commercial fluorinated polymers]

As commercial fluorinated polymers, the following materials were subjected for evaluation.

- Fluon PTFE L173JE (manufactured by AGC Inc.): tetrafluoroethylene polymer
- Fluon PFA P-63 (manufactured by AGC Inc.): tetrafluoroethylene/ perfluoropropyl vinyl ether copolymer
- TEFLON AF 1600 (manufactured by DuPont): tetrafluoroethylene/perfluoro(2,2-dimethyl-1,3-dioxole) copolymer
- kynar 301F (manufactured by ARKEMA): vinylidene fluoride polymer
- kynar 720 (manufactured by ARKEMA): vinylidene fluoride polymer

<Evaluation>

The obtained fluorinated polymers were subjected to the following evaluations 1 to 4.

[Evaluation 1: chamber pressure change at the time of deposition]

0.1 g of the fluorinated polymer was put in a vacuum deposition apparatus, the pressure in the chamber was reduced to $10^{-4}$ Pa or lower, and the fluorinated polymer was deposited in a thickness of 200 nm at a deposition rate of 0.1 nm/sec. On that occasion, the pressure in the chamber was monitored, and the maximum value of the pressure at the time of deposition was measured. The pressure increase ratio was determined from the measured value in accordance with the following formula.

$$\text{(Chamber pressure increase ratio at the time of deposition)} = \text{(maximum pressure during deposition)}/\text{(initial pressure before deposition)}$$

A fluorinated polymer with the chamber pressure increase ratio of two times or less was evaluated as "favorable" and a fluorinated polymer with the increase ratio of higher than 2 times was evaluated as "poor".

A fluorinated polymer evaluated as poor in this evaluation was not any more subjected to the following evaluation of the electrically conductive film, since such a polymer might contaminate the chamber.

[Evaluation 2: evaluation 1 of patterning property of electrically conductive film]

(Preparation of transmittance measurement sample)

A 25 mm×25 mm×0.525 mm quartz substrate was used. On the plan-view center of the quartz substrate, using a metal mask having 21 mm×5 mm rectangular openings, the fluorinated polymer was deposited to prepare a quartz substrate having a resin film.

Deposition of the fluorinated polymer was conducted at a deposition rate of 0.1 nm/sec. Further, deposition of the fluorinated polymer was conducted until the film thickness reached 10 nm as measured by a film thickness meter attached to the deposition apparatus.

Then, on the entire quartz substrate having a resin film, Ag was deposited from above the resin film without using a mask to prepare an electrically conductive film sample for transmittance measurement.

Deposition of Ag was conducted at a deposition rate of 0.05 nm/sec. Further, deposition of Ag was conducted until the film thickness reached 15 nm as measured by a film thickness meter attached to the deposition apparatus.

(Measurement of transmittance)

The transmittance of the prepared electrically conductive film sample was measured by using a spectrophotometer (manufactured by Shimadzu Corporation, model: UV-3600 Plus). From the obtained results, it was judged that the higher the transmittance was, the better the patterning property was (the easier the patterning would be).

[Evaluation 3: evaluation 2 of patterning property of electrically conductive film]

(Preparation of total light transmittance measurement sample)

A 25 mm×25 mm×0.525 mm quartz substrate was used. On the plan-view center of the quartz substrate, using a metal mask having 21 mm×5 mm rectangular openings, the fluorinated polymer was deposited to prepare a quartz substrate having a resin film.

Deposition of the fluorinated polymer was conducted at a deposition rate of 0.1 nm/sec. Further, deposition of the fluorinated polymer was conducted until the film thickness reached 50 nm as measured by a film thickness meter

attached to the deposition apparatus.

Then, on the entire quartz substrate having a resin film, Ag was deposited from above the resin film without using a mask to prepare an electrically conductive film sample for transmittance measurement.

Deposition of Ag was conducted under 2 conditions that is at deposition rates of 0.05 nm/sec and 0.2 nm/sec, until the film thickness reached 70 nm as measured by a film thickness meter attached to the deposition apparatus.

(Measurement of total light transmittance)

With respect to the electrically conductive film sample for total light transmittance measurement, the total light transmittance at the second region was measured by a haze meter (manufactured by Suga Test Instruments Co., Ltd., model HZ-V3, measurement light: illuminant D65).

[Evaluation 4: evaluation of flexibility of fluorinated polymer]

Flexibility of the fluorinated polymer was evaluated by the storage elastic modulus (G') measured by a dynamic viscoelasticity measuring device (manufactured by Anton Paar, MCR502) and a heating furnace for a viscoelasticity measuring device (manufactured by Anton Paar, CTD450).

Specifically, a sample (the fluorinated polymer) was heated to the melting point or higher and then its temperature was decreased at constant temperature-decreasing mode at 2°C/min, and using the above measuring device, the storage elastic modulus (G') was measured with a distortion of 0.01 % at a frequency of 1Hz.

From the obtained results, flexibility of the fluorinated polymer was evaluated based on the following standards.

A: storage elastic modulus (G') at 40°C was less than $4\times10^7$ Pa
B: storage elastic modulus (G') at 40°C was $4\times10^7$ Pa or more

[Ex. 1 to 7]

Using the above fluorinated polymers C1, X1, D1, E1, G1, I1 and Y1, resin films were formed and subjected to evaluations 1 to 4.

[Ex. 8]

In the same manner as in Ex. 1 except that Fluon PTFE L173JE was used as the fluorinated polymer to form a resin film, evaluations were conducted.

The chamber pressure increase at the time of deposition was remarkably high in evaluation 1, no other evaluations were conducted.

[Ex. 9]

In the same manner as in Ex. 1 except that Fluon PFA P-63 was used as the fluorinated polymer to form a resin film, evaluations were conducted.

The chamber pressure increase at the time of deposition was remarkably high in evaluation 1, no other evaluations were conducted.

[Ex. 10]

In the same manner as in Ex. 1 except that TEFLON AF 1600 was used as the fluorinated polymer to form a resin film, evaluations were conducted.

The chamber pressure increase at the time of deposition was remarkably high in evaluation 1, no other evaluations were conducted.

[Ex. 11]

In the same manner as in Ex. 1 except that kynar 301F was used as the fluorinated polymer to form a resin film, evaluations were conducted.

The chamber pressure increase at the time of deposition was remarkably high in evaluation 1, no other evaluations were conducted.

[Ex. 12]

In the same manner as in Ex. 1 except that kynar 720 was used as the fluorinated polymer to form a resin film, evaluations were conducted.

The chamber pressure increase at the time of deposition was remarkably high in evaluation 1, no other evaluations were conducted.

Among the above Ex. 1 to 12, Ex. 1, 2 and 7 correspond to Examples of the present invention, Ex. 3 to 6 correspond to Reference Examples, and Ex. 8 to 12 correspond to Comparative Examples. The evaluations results are shown in Tables 1 to 3. Table 1 illustrates physical properties of the materials of the resin films, Table 2 illustrates the results of evaluations 1 and 2, and Table 3 illustrates the results of evaluations 3 and 4. In Tables, "-" indicates that no data is present.

[Table 1]

| | Resinfilm material | Melting point (°C) | 100% thermogravimetric loss temperature (°C) | Range of thermogravimetric loss temperature (°C) | Surface energy (mN/m) | $CF_3$ concentration (mmol/g) | Fluorine atom content (%) |
|---|---|---|---|---|---|---|---|
| Ex. 1 | C1 | 170 | 327 | 34 | 15 | 1.1 | 75 |
| Ex. 2 | X1 | 195 | 300 | 52 | 15 | 1 | 75 |
| Ex. 3 | D1 | 230 | 315 | 42 | 15 | 0.8 | 75 |
| Ex. 4 | E1 | 262 | 326 | 90 | 15 | 0.55 | 75 |
| Ex. 5 | G1 | 267 | 280 | 25 | 14 | 0.38 | 76 |
| Ex. 6 | I1 | 290 | 340 | 46 | 16 | 0.2 | 76 |
| Ex. 7 | Y1 | 190 | 330 | 120 | 15 | 1.8 | 76 |
| Ex. 8 | fluon PTFE | - | 500< | 200< | - | 0 | 76 |
| Ex. 9 | fluon PFA | - | 500< | 200< | - | 0.11 | 76 |
| Ex. 10 | TEFLON AF | - | 500< | 200< | - | 6.7 | 65 |
| Ex. 11 | kynar 301F | - | 500< | 200< | - | 0 | 59 |
| Ex. 12 | kynar 720 | - | 500< | 200< | - | 0 | 59 |

[Table 2]

| | Resin film material | (Evaluation 1) pressure increase ratio | (Evaluation 2) light transmittance at second region (%) | | | |
|---|---|---|---|---|---|---|
| | | | B (436 nm) | G (546 nm) | R (700 nm) | NIR (940 nm) |
| Ex. 1 | C1 | 1.2 | 96 | 99 | 100 | 99 |

(continued)

| | Resin film material | (Evaluation 1) pressure increase ratio | (Evaluation 2) light transmittance at second region (%) | | | |
|---|---|---|---|---|---|---|
| | | | B (436 nm) | G (546 nm) | R (700 nm) | NIR (940 nm) |
| Ex. 2 | X1 | 1.2 | 92 | 98 | 99 | 99 |
| Ex. 3 | D1 | 1.2 | 87 | 97 | 99 | 99 |
| Ex. 4 | E1 | 1.6 | 75 | 94 | 99 | 99 |
| Ex. 5 | G1 | 1 | 58 | 82 | 95 | 97 |
| Ex. 6 | I1 | 1.4 | 37 | 50 | 77 | 92 |
| Ex. 7 | Y1 | 1.3 | 90 | 95 | 99 | 99 |
| Ex.8 | fluon PTFE | 25 | - | - | - | - |
| Ex. 9 | fluon PFA | 45 | - | - | - | - |
| Ex. 10 | TEFLON AF | 34 | - | - | - | - |
| Ex. 11 | kynar 301F | 111 | - | - | - | - |
| Ex. 12 | kynar 720 | 200 | - | - | - | - |

[Table 3]

| | Resin film material | (Evaluation 3) total light transmittance at second region (%) | | (Evaluation 4) Flexibility | |
|---|---|---|---|---|---|
| | | Ag deposition rate | | Storage elastic modulus G' (Pa, 40°C) | Evaluation |
| | | 0.05 nm/s | 0.2 nm/s | | |
| Ex. 1 | C1 | 91 | 86 | $7\times10^6$ Pa | A |
| Ex. 2 | X1 | 90 | 95 | $2\times10^7$ Pa | A |
| Ex. 3 | D1 | 33 | 37 | $4\times10^7$ Pa or more | B |
| Ex. 4 | E1 | - | - | $4\times10^7$ Pa or more | B |
| Ex. 5 | G1 | - | - | $4\times10^7$ Pa or more | B |
| Ex. 6 | I1 | - | - | $4\times10^7$ Pa or more | B |
| Ex. 7 | Y1 | 85 | 80 | $3\times10^7$ Pa | A |

It was found from the results of evaluations that in Ex. 1 to 7, no chamber pressure increase at the time of deposition was observed, and no depolymerization, thermal decomposition, nor generation of an out gas was observed.

Further, in Ex. 1, 2 and 7 in which the requirements (1) to (3) were satisfied, a high transmittance of 80% or more was observed in evaluation 3.

Further, in Ex. 1 and 2 in which the PPVE content was 11 mol% or more and in Ex. 7 in which the HFP content was 18 mol% or more, in evaluation 4, the storage elastic modulus (G') at 40°C was less than $4\times10^7$ Pa, and high flexibility was confirmed.

Whereas in Ex. 8 to 12, a chamber pressure increase at the time of deposition was confirmed, and thus it was found that deposition would be accompanied by depolymerization, thermal decomposition, and generation of an out gas, such being substantially unsuitable for preparation of the resin film according to the present embodiment.

Further, in Ex. 3 (Reference Example) in which the requirement (1) was not satisfied, there was no definite difference with Ex. 1, 2 and 7 with respect to evaluation 2, however, Ex. 3 was apparently inferior in the results of

evaluation 3 to Ex. 1, 2 and 7. The results in Ex. 4 to 6 in which the requirement (1) was not satisfied are expected to have the same tendency as in Ex. 4.

From the above results, the present invention was confirmed to be useful.

## INDUSTRIAL APPLICABILITY

The present invention provides a fluorinated polymer capable of deposition without thermal decomposition or generation of an out gas, and is useful not only as a metal patterning material for e.g. electrodes but also as a material of an OCA (optical clear adhesive) or an OCR (optical clear resin) for displays and an optical thin film such as a light extraction film. The thin film formed of the fluorinated polymer of the present invention as a material is useful as an optical thin film having a low refractive index.

The entire disclosures of Japanese Patent Application No. 2020-030460 filed on February 26, 2020, Japanese Patent Application No. 2020-112962 filed on June 30, 2020 and Japanese Patent Application No. 2021-006634 filed on January 19, 2021 including specifications, claims, drawings and summaries are incorporated herein by reference in their entireties.

## REFERENCE SYMBOLS

1, 11, 12: electrically conductive film, 10, 116: first film, 10A: first region, 10B: second region, 10X: first electrically conductive material, 15, 117: resin film, 20, 118: second film, 20a, 50a: surface, 50: substrate, 110: substrate, 111: anode, 115: cathode, P: fluorinated polymer, M: mask

## Claims

**1.** A fluorinated polymer which satisfies the following requirements (1) to (3):

(1) the melting point is less than 200°C or no melting point is observed,
(2) the thermogravimetric loss rate when the temperature is increased at a temperature-increasing rate of 2°C/min under a pressure of $1\times10^{-3}$ Pa, substantially reaches 100% at 400°C or lower,
(3) when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 200°C.

**2.** The fluorinated polymer according to Claim 1, wherein the storage elastic modulus at 40°C is less than $4\times10^{7}$ Pa.

**3.** The fluorinated polymer according to Claim 1 or 2, which has units derived from a fluoroolefin.

**4.** The fluorinated polymer according to Claim 3, which has at least units derived from tetrafluoroethylene.

**5.** The fluorinated polymer according to Claim 3 or 4, which has units derived from a perfluoroalkyl vinyl ether.

**6.** The fluorinated polymer according to Claim 5, wherein the perfluoroalkyl vinyl ether is perfluoropropyl vinyl ether.

**7.** The fluorinated polymer according to Claim 6, wherein the content of the units derived from perfluoropropyl vinyl ether to all units is 11 mol% or more.

**8.** The fluorinated polymer according to Claim 3 or 4, which further has units derived from hexafluoropropylene.

**9.** The fluorinated polymer according to Claim 8, wherein the content of the units derived from hexafluoropropylene to all units is 18 mol% or more.

**10.** The fluorinated polymer according to any one of Claims 1 to 9, which has a trifluoromethyl moiety, and has a content of the trifluoromethyl moiety of 0.1 mmol/g or more.

**11.** A resin film formed of the fluorinated polymer as defined in any one of Claims 1 to 10 as a material.

**12.** A photoelectronic element, comprising the resin film as defined in Claim 11.

Fig. 1

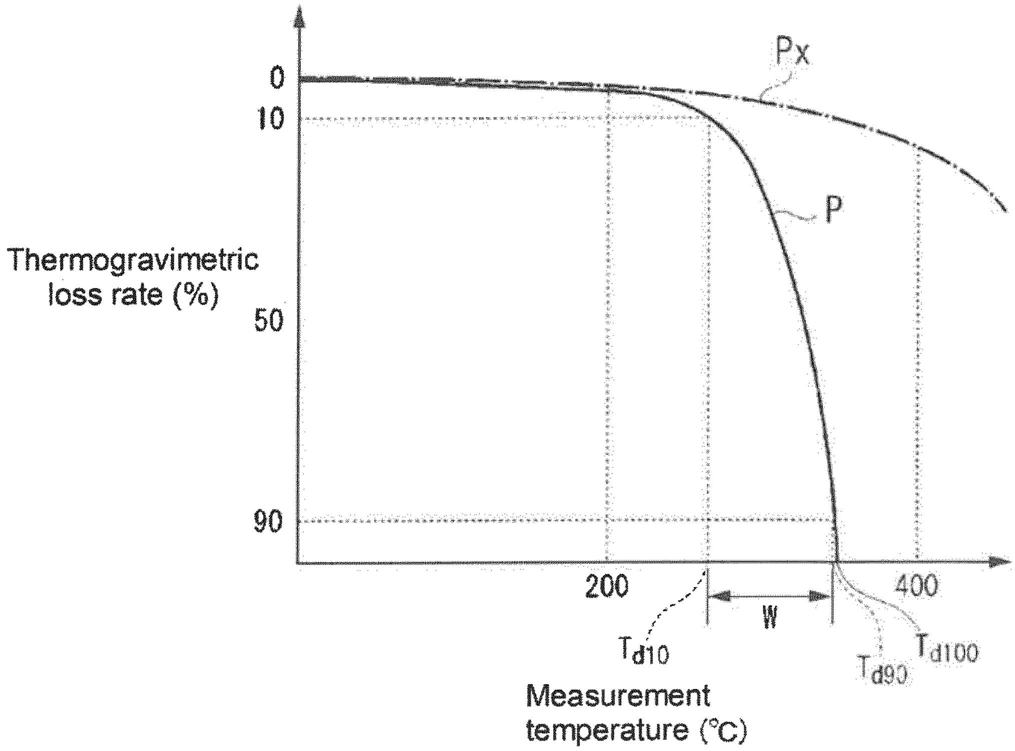
Px
P
0
10
50
90
Thermogravimetric loss rate (%)
200
400
W
Td10
Td90
Td100
Measurement temperature (℃)

Fig. 2

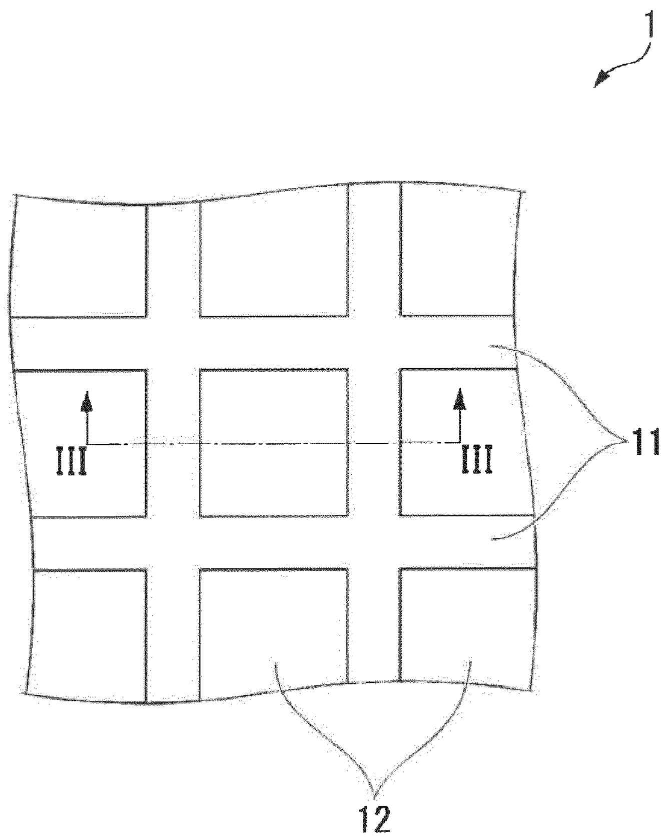
1
III
III
11
12

Fig. 3

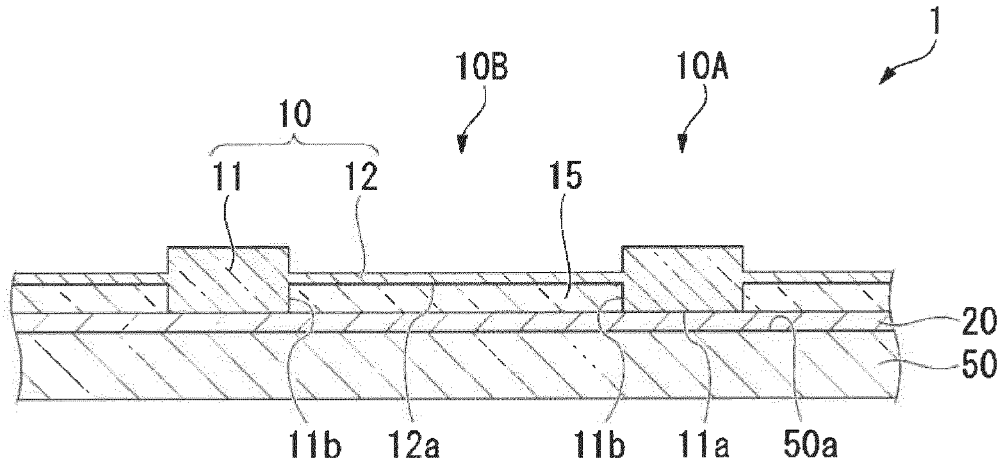


Fig. 4

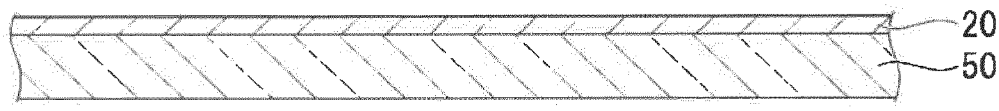


Fig. 5

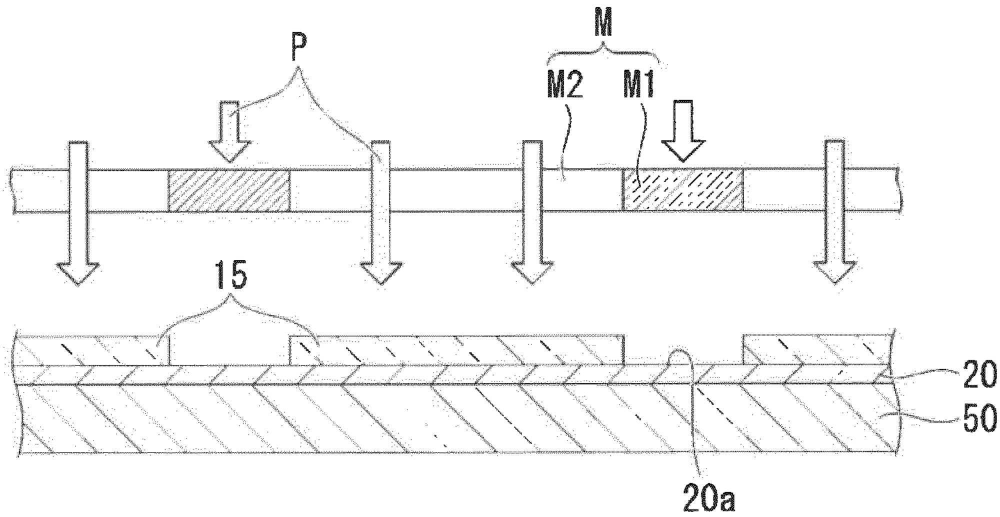


Fig. 6

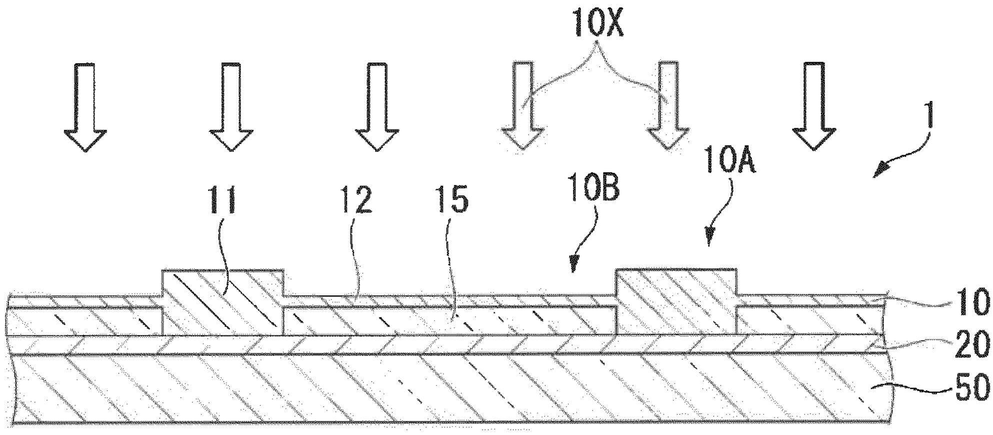

Fig. 7

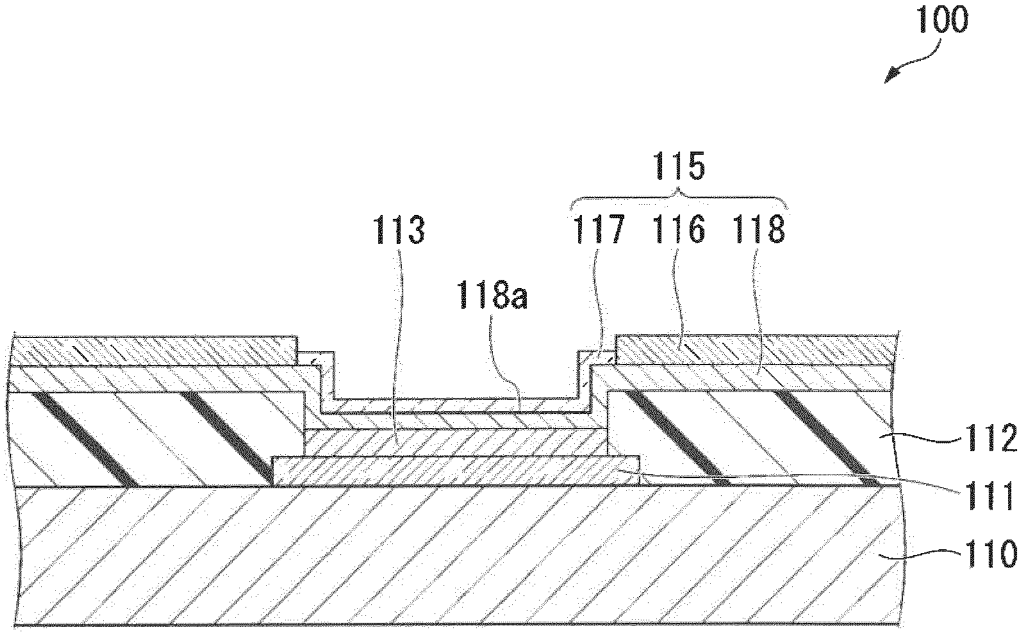

## INTERNATIONAL SEARCH REPORT

International application No.
PCT/JP2021/006909

A. CLASSIFICATION OF SUBJECT MATTER

C08F 14/18(2006.01)i; C08F 14/26(2006.01)i; C08L 27/12(2006.01)i; H01L 31/10(2006.01)i; H01B 5/14(2006.01)i; H01B 13/00(2006.01)i; H05B 33/10(2006.01)i; H01L 51/50(2006.01)i; H05B 33/22(2006.01)i; H05B 33/26(2006.01)i

FI: H05B33/26 Z; C08L27/12; H05B33/14 A; H05B33/10; H05B33/22 D; H05B33/22 B; H01L31/10 H; H01B5/14 A; H01B5/14 B; H01B13/00 503B; H01B13/00 503D; C08F14/26; H05B33/22 Z; C08F14/18

According to International Patent Classification (IPC) or to both national classification and IPC

B. FIELDS SEARCHED

Minimum documentation searched (classification system followed by classification symbols)

C08F14/18; C08F14/26; C08L27/12; H01L31/10; H01B5/14; H01B13/00; H05B33/10; H01L51/50; H05B33/22; H05B33/26

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2008/133088 A1 (ASAHI GLASS CO., LTD.) 06 November 2008 (2008-11-06) | 1-12 |
| A | JP 2018-126953 A (RICOH CO., LTD.) 16 August 2018 (2018-08-16) | 1-12 |
| A | JP 8-239242 A (CENTRAL GLASS CO., LTD.) 11 September 1996 (1996-09-17) | 1-12 |
| A | JP 9-25559 A (CENTRAL GLASS CO., LTD.) 28 January 1997 (1997-01-28) | 1-12 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 April 2021 (20.04.2021) | 11 May 2021 (11.05.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/006909

C (Continuation). DOCUMENTS CONSIDERED TO BE RELEVANT

| Category* | Citation of document, with indication, where appropriate, of the relevant passages | Relevant to claim No. |
|---|---|---|
| A | JP 11-1593 A (SUMITOMO CHEMICAL INDUSTRY COMPANY LIMITED) 06 January 1999 (1999-01-06) | 1-12 |
| A | WO 2005/100420 A1 (DAIKIN INDUSTRIES, LTD.) 27 October 2005 (2005-10-27) | 1-12 |
| A | WO 2009/096342 A1 (ASAHI GLASS CO., LTD.) 06 August 2009 (2009-08-06) | 1-12 |
| A | JP 2009-520351 A (E.I. DU PONT DE NEMOURS AND COMPANY) 16 January 2009 (2009-01-16) | 1-12 |

Form PCT/ISA/210 (continuation of second sheet) (January 2015)

**INTERNATIONAL SEARCH REPORT**
Information on patent family members

International application No.
PCT/JP2021/006909

| Patent Documents referred in the Report | Publication Date | Patent Family | Publication Date |
|---|---|---|---|
| WO 2008/133088 A1 | 06 Nov. 2008 | US 2010/0080903 A1<br>EP 2143818 A1<br>CN 101663415 A<br>KR 10-2010-0014816 A<br>RU 2009142805 A<br>TW 200909597 A | |
| JP 2018-126953 A | 16 Aug. 2018 | (Family: none) | |
| JP 8-239242 A | 17 Sep. 1996 | (Family: none) | |
| JP 9-25559 A | 28 Jan. 1997 | (Family: none) | |
| JP 11-1593 A | 06 Jan. 1999 | (Family: none) | |
| WO 2005/100420 A1 | 27 Oct. 2005 | US 2007/0219333 A1<br>EP 1741732 A1<br>KR 10-2007-0009691 A<br>CN 1942492 A<br>TW 200536865 A | |
| WO 2009/096342 A1 | 06 Aug. 2009 | US 2010/0240791 A1<br>EP 2239284 A1<br>CN 101925622 A<br>KR 10-2010-0107446 A<br>TW 200940572 A | |
| JP 2009-526351 A | 16 Jul. 2009 | US 2008/0003449 A1<br>WO 2007/092296 A2<br>KR 10-2008-0103062 A<br>CN 101379162 A<br>TW 2007 40604 A<br>EP 2387041 A1<br>EP 2387042 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 10270033 B
- JP H11152310 A
- JP 2020030460 A
- JP 2020112962 A
- JP 2021006634 A